(19) Europäisches Patentamt
European Patent Office
Office européen des brevets

(11) **EP 2 290 393 B1**

(12) **EUROPÄISCHE PATENTSCHRIFT**

(45) Veröffentlichungstag und Bekanntmachung des Hinweises auf die Patenterteilung:
**19.06.2019   Patentblatt 2019/25**

(51) Int Cl.:
*G01S 7/486* *(2006.01)*       *H01L 27/146* *(2006.01)*
*G01S 17/89* *(2006.01)*       *G01S 17/10* *(2006.01)*

(21) Anmeldenummer: **10172810.3**

(22) Anmeldetag: **13.08.2010**

(54) **Konzept zur optischen Abstandsmessung**

Concept for optical distance measurement

Concept de mesure optique de distance

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **14.08.2009   DE 102009037596**

(43) Veröffentlichungstag der Anmeldung:
**02.03.2011   Patentblatt 2011/09**

(73) Patentinhaber: **Volkswagen Aktiengesellschaft 38440 Wolfsburg (DE)**

(72) Erfinder:
• **Spickermann, Andreas 46244 Bottrop (DE)**
• **Brockherde, Werner 47259 Duisburg (DE)**
• **Hosticka, Bedrich J. 45478 Mülheim a. d. R. (DE)**

(74) Vertreter: **Schenk, Markus et al Schoppe, Zimmermann, Stöckeler Zinkler, Schenk & Partner mbB Patentanwälte Radlkoferstrasse 2 81373 München (DE)**

(56) Entgegenhaltungen:
**EP-A1- 2 322 953     US-A1- 2009 134 396**

• **TOMONARI SAWADA ET AL: "TOF range image sensor using a range-shift technique", 2008 IEEE SENSORS,LECCE, ITALY, IEEE, PISCATAWAY, NJ, USA, 26. Oktober 2008 (2008-10-26), Seiten 1390-1393, XP031375344, ISBN: 978-1-4244-2580-8**
• **DURINI D ET AL: "Time-of-Flight 3-D Imaging Pixel Structures in Standard CMOS Processes", IEEE JOURNAL OF SOLID-STATE CIRCUITS, IEEE SERVICE CENTER, PISCATAWAY, NJ, USA, vol. 40, no. 7, 1 July 2008 (2008-07-01), pages 1594-1602, XP011229233, ISSN: 0018-9200**

**Beschreibung**

Die vorliegende Erfindung bezieht sich auf ein Konzept zur optischen Abstandsmessung, wie es beispielsweise bei einer sog. ToF (Time of Flight) dreidimensionalen Bilderfassung eingesetzt werden kann.

Anwendungen, bei denen optische Strahlung erfasst werden soll, sind vielfältig. Kostengünstige CMOS- (Complementary Metal-Oxide-Semiconductor) Bildsensoren und Kamerasysteme sind heutzutage zu ständigen Begleitern unseres alltäglichen Lebens geworden. Speziell im Consumerbereich sind Digital- und Handykameras zu einem Massenprodukt herangewachsen und kaum noch weg zu denken. Aber auch im Bereich von Spezialanwendungen werden kostengünstige CMOS-Kameras im Vergleich zu hochwertigen, aber auch weitaus teureren CCD-Bildsensoren (CCD = Charge Coupled Device) immer interessanter. Besonders die Realisierung eines Photodetektors und einer weiterverarbeitenden Ausleseelektronik auf einem Chip gemäß dem sog. "Camera-on-a-Chip"-Ansatz stellt einen großen Vorteil der CMOS-Bildsensorik gegenüber der CCD-Technologie dar.

Ein Spezialgebiet der CMOS-Bildsensorik befasst sich mit der kontaktlosen Distanzmessung basierend auf dem sog. Time-of-Flight-(ToF)-Prinzip. Hierbei wird eine aktive Beleuchtung in Form von gepulst oder kontinuierlich modulierter optischer Strahlung genutzt, um direkt oder indirekt über die Laufzeit der reflektierten optischen Strahlung einen Abstand des Sensors zu einem Messobjekt zu bestimmen. Je nach Anwendungsgebiet ergeben sich u.U. hohe Performaceanforderungen für einen solchen ToF-Sensor. Intelligente Abstandsmesssysteme im Automobil müssen beispielsweise mit sehr hohen Geschwindigkeiten arbeiten, um in Echtzeit Messdaten liefern zu können. Gleichzeitig muss der Sensor auch bei starken variierenden Umgebungseinflüssen, wie Nebel, Dunkelheit, schlechten Witterungsverhältnissen oder extremen Gegenlichtsituationen einwandfrei funktionieren. Mit hochdynamischen CMOS-Bildsensoren und effizienten Auslesemethoden zur Hintergrundlichtunterdrückung lassen sich diese Anforderungen erfüllen.

Neben einer Nutzung als Abstandssensor im Automobil gibt es weitere Anwendungsgebiete von ToF-Sensoren, wie z. B. dreidimensionale Inspektions-/Positionierungssysteme oder Automotive-Systeme. Hierbei ergeben sich Einsatzgebiete insbesondere für Kfz-Innenraumüberwachung, Airbag-Steuerung, Diebstahlsicherungssysteme, Fahrspurerkennungssysteme, Pre-Crash-Sensorik, Fußgängerschutz und Einparkhilfen. Weiter können ToF-Sensoren zur Topographievermessung, für Überwachungssysteme im Security-Bereich, für bildgebende Systeme für die Medizintechnik, in der Unterhaltungselektronik (z. B. Spielekonsolen) oder zur funktionalen Maschinensicherheit eingesetzt werden.

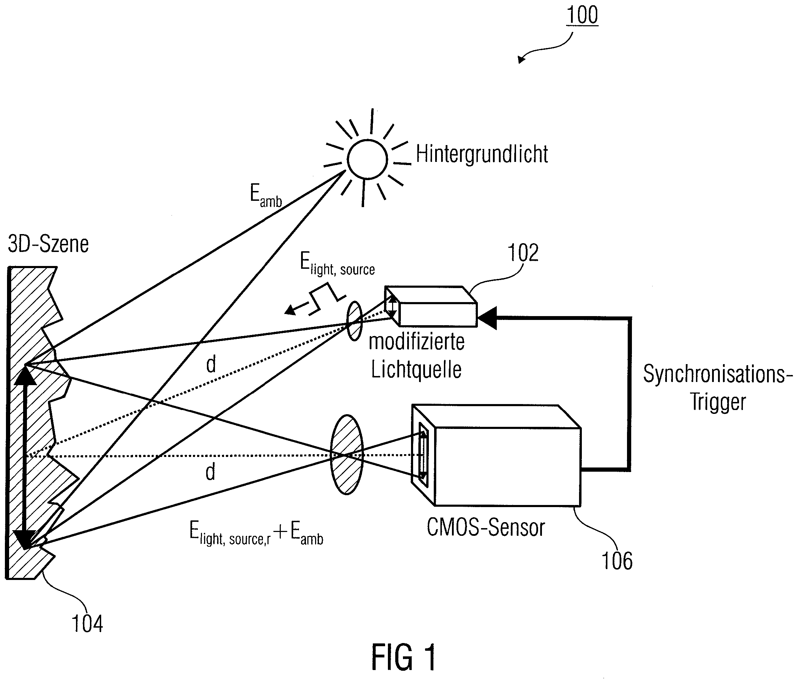

In den letzten Jahren haben sich verschiedene Methoden zur ToF-basierten Abstands- bzw. Tiefenmessung entwickelt. Fig. 1 zeigt in einer schematischen Darstellung einen Aufbau einer Messanordnung 100, die jedoch für sämtliche ToF-Systeme identisch ist.

Eine modulierte Strahlungs- bzw. Lichtquelle 102 beleuchtet hierbei ein Messobjekt 104 im Raum mit einer Bestrahlungsstärke $E_{light,source}$. Nach einer Reflektion eines Lichtstrahls oder Lichtpulses am Messobjekt 104, trifft er nach Durchlaufen einer Strecke 2d auf einen CMOS-Bildsensor 106. Dabei bedeutet d eine Entfernung zwischen Messsystem und Messobjekt 104. Das am Bildsensor 106 auftreffende Licht setzt sich einerseits aus einem reflektierten Lichtanteil $E_{light,source,r}$ und andererseits aus einem Hintergrundlicht $E_{amb}$ zusammen. Durch eine Synchronisation von Lichtquelle 102 und Bildsensor 106 lässt sich eine Laufzeitverzögerung $T_d$ des emittierten Lichts ermitteln, welche gemäß

$$d = \frac{c}{2} T_d \qquad\qquad\qquad (1)$$

direkt proportional zur Distanz d zwischen Sensor 106 und Messobjekt 104 ist. In Gl. (1) bedeutet c die Lichtgeschwindigkeit.

Typischerweise ist der Bildsensor 106 als Halbleiter-Photosensor und -bildwandler ausgebildet, der auch als sog. Active-Pixel-Sensor (APS) bezeichnet wird und jedem Pixel zugeordnete, aktive Schaltungselemente aufweist, insbesondere Halbleiterbildwandler, die Photodioden und/oder Photogates mit sog. korrelierter Doppelabtastung (CDS/Correlated Double Sampling) verwenden. Active Pixel Sensoren sind Halbleiterbildwandler, in denen jedes Pixel typische Halbleiter-Pixelelemente enthält, u.a. photoempfindliche Bereiche, Rückstellmittel, Mittel zur Umwandlung von Ladung in Spannung und zudem alle Teile eines Verstärkers. Die in einem Pixel durch Beleuchtung generierte Photoladung wird in eine entsprechende Spannung oder einen entsprechenden Strom umgewandelt.

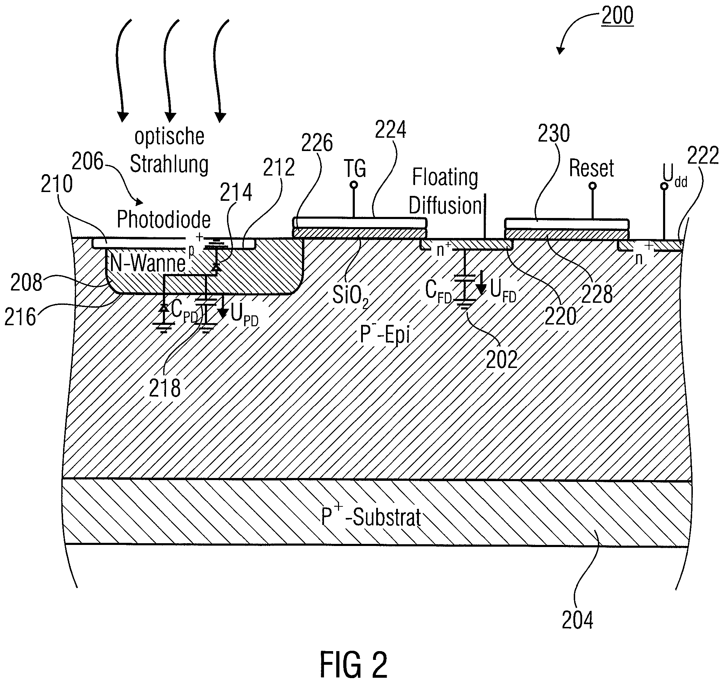

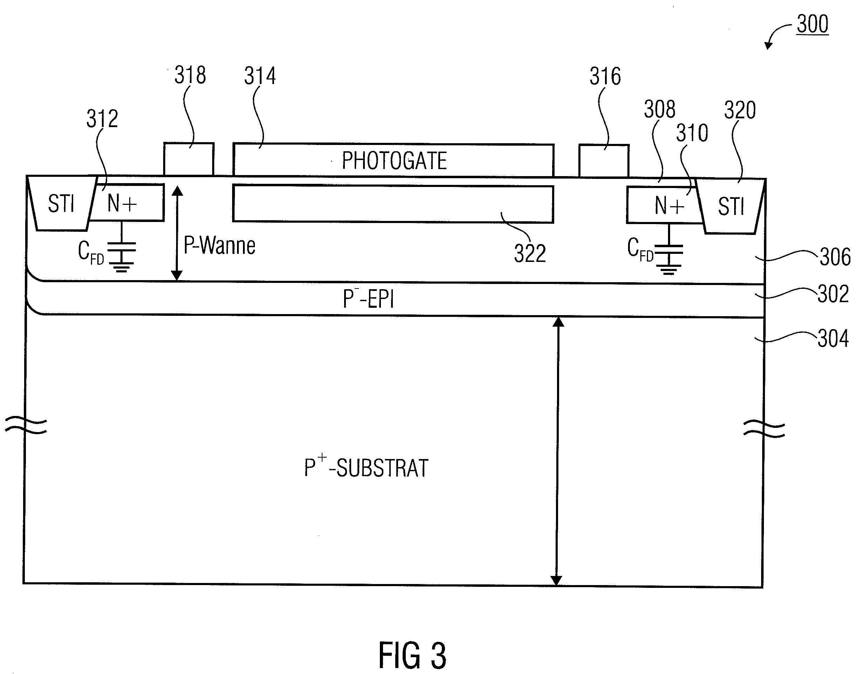

Anhand der nachfolgenden beiden Fig. 2 und 3 werden nun bekannte ToF-Pixelstrukturen, die im Zusammenhang mit der vorliegenden Erfindung eingesetzt bzw. modifiziert werden können, beschrieben.

Fig. 2 zeigt in einer schematischen Querschnittsdarstellung eine Pixelstruktur 200 basierend auf einer gepinnten Photodiode.

Die ToF-Pixelstruktur 200 ist in einer p⁻-epi-Schicht bzw. einer niedrig dotierten epitaktischen p-Schicht 202 gebildet, die auf einem p⁺- bzw. hochdotierten p-Substrat 204 angeordnet ist. Wie es zu sehen ist, ist die gepinnte Photodiode 206 aus einer n-dotierten Wanne 208 in der Schicht 202 gebildet, an deren freiliegenden Seite wiederum ein p⁺-dotierter Bereich 210 angeordnet ist. Der p⁺-dotierte Bereich 210 bewirkt, dass ein Potentialtopf der Photodiode 206 von der Oberfläche entfernt wird und somit beispielsweise Dunkelströme minimiert werden können. Dazu wird der p$^+$-dotierte Bereich 210 auf Masse gelegt. An den Rändern zwischen der n-dotierten Wanne 208, dem p$^+$-dotierten Bereich 210 und der p$^-$-epi-Schicht 202 entsteht eine Raumladungszone, die n-Wanne wird an freien Ladungsträgern verarmt. Mit Bezugzeichen 218 ist eine parasitäre Kapazität gekennzeichnet, deren spektrale Empfindlichkeit vernachlässigbar ist. An der freiliegenden Oberfläche der Schicht 202 sind zwei weitere n$^+$-dotierte Bereiche 220 und 222 gebildet, wobei der erstgenannte zusammen mit der n-Wanne 210 einen Transistor bzw. einen MOS-Transistor (Metal-Oxide-Semiconductor) bildet, der im Folgenden auch als Transfer-Schalter oder Transfer-Gate TG bezeichnet wird, und eine Gate-Elektrode 224 aufweist, die sich oberhalb der n-Wanne 210 und dem n$^+$-Bereich 220 und zwischen denselben erstreckt und durch eine Siliziumdioxidschicht 226 von der n-Wanne 210 und dem n$^+$-Bereich 220 getrennt ist. Auf ähnliche Weise erstreckt sich eine Schichtanordnung aus einer Siliziumdioxid-Schicht 228 und einer Gateelektrode 230 zwischen dem n$^+$-Bereich 220 und dem n$^+$-Bereich 222, um einen als Reset-Schalter fungierenden Transistor bzw. MOS-Transistor zu bilden. Wie es in Fig. 2 gezeigt ist, bildet der pn-Übergang zwischen dem n$^+$-Bereich 220 und der p$^-$-Schicht 202 eine Auslese- bzw. Auswertekapazität $C_{FD}$, die auch als Floating-Diffusion-Kapazität bezeichnet wird. Das Transfer-Gate TG und der Reset-Transistor können nun durch eine Steuerschaltung (nicht gezeigt) so angesteuert werden, dass durch eine Beleuchtung eines durch die Pinned-Photodiode gebildeten photoaktiven Bereichs Ladungsträger über das Transfer-Gate von dem photoaktiven Bereich zu der Auswertekapazität $C_{FD}$ fließen und von dort weiter verarbeitet werden können, um darauf basierend eine Entfernungsmessung durchzuführen. Das Transfer-Gate ist also ein Schalter, der hier den durch die Photodiode 214 gebildeten photoaktiven Bereich mit der durch den Übergang zwischen dem n$^+$-Bereich 220 und der p$^-$-Schicht 202 gebildeten Auswertekapazität $C_{FD}$ verbindet, wenn der Schalter geschlossen ist, d.h. die Gate-Elektrode 224 entsprechend angesteuert wird.

Eine weitere beispielhafte ToF-Pixelstruktur 300 basierend auf einem Photo-Gate ist im Querschnitt in Fig. 3 gezeigt.

Wie die Pixelstruktur 200 gemäß Fig. 2, so ist auch die Pixelstruktur 300 gemäß Fig. 3 auf einer niedrig-dotierten epitaktischen p-Schicht 302 gebildet, die auf einem hochdotierten p-Substrat 304 angeordnet ist. Oberhalb der p$^-$-Schicht 302 ist lediglich exemplarisch eine als p-Wanne bezeichnete Schicht 306 angeordnet, in der verschiedene Komponenten der ToF-Pixelstruktur 300 angeordnet sind, wie es im Nachfolgenden beschrieben wird.

Zwischen der p-Wanne 306 und einer darauf angeordneten Siliziumdioxidschicht 308 sind zwei sog. n$^+$-Floating-Diffusion Bereiche 310 und 312 (Diffusionsgebiete) gebildet. Diese Floating-Diffusion-Bereiche sind kapazitiv, d. h., fähig, Ladungsträger zu speichern, was durch $C_{FD}$ angedeutet ist. Gesteuert werden kann das Pixelelement 300 mittels dreier Elektroden bzw. Gates 314, 316 und 318, die typischerweise aus polykristallinem Silizium (Polysilizium) oberhalb der Siliziumdioxidschicht 308 angeordnet sind. Herkömmliche STI-Strukturen (Shallow Trench Isolation) 320 sind seitlich außerhalb der n$^+$-Floating-Diffusion Bereiche 310 und 312 angeordnet, um Leckströme in ein benachbartes Pixelelement (nicht gezeigt) zu vermeiden.

Die Pixelstruktur 300 fungiert als ein Photodetektor, um durch Photonen, die von einem Messobjekt 104 reflektiert werden und in die Pixelstruktur 300 eintreten, Elektronen-Loch-Paare, je nach Eindringtiefe der einfallenden Photonen, in der kristallinen Struktur des Siliziumhalbleitermaterials zu generieren. Die Struktur 300 wird generell als Photogate-Photodetektor bezeichnet, da ein von dem Photogate 314 ausgehendes elektrisches Feld eine Verarmungszone 322 in der darunterliegenden p-Wanne 306 zur Folge hat, so dass sich dort aufgrund einer Lichteinstrahlung Ladungsträger ansammeln. Die Verarmungszone 322 beginnt an der Oberfläche der p-Wanne 306 und erstreckt sich in Richtung des darunterliegenden p$^+$-Substrats 304. Die Tiefe der Verarmungszone 322 hängt von einer Dicke der Siliziumdioxidschicht 308, einer an das Photogate 314 angelegten Spannung, einer Dotierung der p-Wanne und einer Dotierung des Substrats ab. Werden die Transfer-Gates 316, 318 angesteuert, wird jeweils ein Ladungsträgerfluss zwischen Verarmungszone 322, d.h. photoaktivem Bereich, und dem jeweiligen Floating-Diffusion Bereich 310, 312 ermöglicht. Die transferierten Ladungsträger bewirken an den durch die Floating-Diffusion Bereiche gebildeten Kapazitäten $C_{FD}$ wiederum Spannungsabfälle, die direkt proportional zur transferierten Ladung sind und gemessen werden können. Werden die Transfer-Gates 316, 318 zu geeigneten Zeiten angesteuert und die resultierenden Ladungen bzw. Spannungen gemessen, können Anfang und Ende eines vom Messobjekt 104 reflektierten Strahlungspulses bestimmt werden. Daraus können wiederum Rückschlüsse auf die Distanz d zu dem Messobjekt 104 geschlossen werden.

Jedoch erschwert eine Überlagerung von Nutzsignalen $E_{light,source,r}$ und Hintergrundlicht $E_{amb}$ maßgeblich die exakte Bestimmung der Laufzeitverzögerung $T_d$ und somit der Genauigkeit der Distanzerfassung. Zur effizienten Hintergrundlichtunterdrückung haben sich verschiedene Verfahren etabliert. In DE 198 33 207 und US 7,186,965 wird jeweils ein Ausleseverfahren beschrieben, welches mit gepulsten Laserquellen arbeitet. Durch Doppelbelichtung einer 3D-Szene (einmal mit Laser und einmal ohne Laser) wird bei diesem Verfahren das Hintergrundlicht bestimmt und durch anschließende Subtraktion eliminiert. Darüber hinaus werden zur Berücksichtigung der Reflektanz des Messobjekts und der entfernungsbedingten Abschwächung des reflektierten Laserpulses zwei verschieden lange, elektronische "Shutter"-Zeitfenster eingesetzt. Insgesamt werden zur Distanzbestimmung somit immer zwei korrespondierende Laserpulszyklen benötigt, was zum einen die Geschwindigkeit des Verfahrens begrenzt und zum anderen die benötigte Laserenergie erhöht. Außerdem kann der zeitliche Versatz zwischen den zwei Laserpulszyklen zu Fehlern bei der Abstandsmessung führen, wenn der Sensor oder das Objekt sich bewegen.

So wird gemäß der Patentanmeldung PCT/EP2009/002570 ein optimiertes Verfahren mit einem elektronischen Doppel-"Shutter" bestehend aus zwei Sample- und Hold-Stufen präsentiert, welches die Bestimmung der abstandsabhängigen Messwerte sowie der Reflektivitätswerte mit nur einem Laserpuls ermöglicht. Beide Verfahren verwenden eine Standardpn-Photodiode und nutzen die Sperrschichtkapazität des pn-Übergangs gleichzeitig als Integrations- und Ausleseknoten. Andere ToF-Verfahren, wie beispielsweise in US 2007/0158770 A1 und US 7436496 B2, verwenden hingegen Photogate- oder Pinned-Photodioden basierte Pixelstrukturen mit wenigstens zwei Transfer-Gates, bei denen das photoaktive Gebiet vom Ausleseknoten, d.h. der Floating-Diffusion, getrennt ist. Durch geschickte Synchronisation von Laserpuls und Ansteuerung der beiden Transfer-Gates wird die Pixelstruktur als eine Art "Ladungsschaukel" betrieben, mit der sich die Zeitverzögerung $T_d$ des reflektierten Laserpulses und somit die Distanz d bestimmen lassen. Eine effiziente Hintergrundlichtunterdrückung wird bei diesem Verfahren nicht beschrieben.

Ähnliche Photogate-Strukturen werden in US 6825455 oder US 7060957 präsentiert. Im Gegensatz zu den gepulsten ToF-Verfahren wird hier jedoch eine kontinuierlich modulierte, sinusförmige Lichtquelle verwendet. Die Distanzinformation lässt sich dabei anhand der Phasenverschiebung des zurückreflektierten Lichts rekonstruieren. Aufgrund der kontinuierlichen Beleuchtung des Raums können sich bei Verwendung dieses Verfahrens allerdings Probleme bei der Einhaltung der Sicherheitsaspekte für den Menschen ergeben. Abhilfe schafft hier nur eine Verringerung der Bestrahlungsstärke, was wiederum zu Problemen bei der Hintergrundlichtunterdrückung führt. Ebenso zeigt sich der Abtastalgorithmus anfällig gegenüber Mehrdeutigkeiten bei der Bestimmung der Phasenlage.

Die US 2009/0134396 A1 beschreibt ein Pixel eines Halbleiterentfernungsmessers, bei dem über entsprechende Gate-Elektroden steuerbar Ladungen, die sich unterhalb einer Lichtempfangs-Gate-Elektrode sammeln, an vier außenliegende Dotierungsregionen verteilbar sind. Die vier Elektroden sind in einer Ebene mit der Photo-Gate-Elektrode um letztere herum und von derselben beabstandet angeordnet.

Ausgehend von diesem Stand der Technik besteht die Aufgabe der vorliegenden Erfindung darin, eine im Hinblick auf Messgeschwindigkeit optimierte Pixelstruktur mit gleichzeitig optimierter Photorausch- und Hintergrundlichtunterdrückung bereitzustellen.

Diese Aufgabe wird mit einer Pixelstruktur zur optischen Abstandsmessung gemäß Anspruch 1, einem System zur optischen Abstandsmessung gemäß Anspruch 13 und einem Verfahren gemäß Anspruch 14 gelöst.

Gemäß einem Ausführungsbeispiel der vorliegenden Erfindung wird eine Pixelstruktur zur optischen Abstandsmessung bereitgestellt, wobei die Pixelstruktur einen photoaktiven Bereich zur Erzeugung von Ladungsträgern ansprechend auf auf den photoaktiven Bereich einfallende optische Strahlung, sowie einen Referenzpotentialanschluss für ein Referenzpotential, das als Ladungsträgersenke wirkt, aufweist. Ferner weist die Pixelstruktur eine Mehrzahl von zumindest drei Auswertekapazitäten in Form von Floatingdiffusion-Bereichen auf, die lateral beabstandet von einer Kante des photoaktiven Bereichs um den photoaktiven Bereich herum angeordnet sind. Ferner weist die Pixelstruktur eine Mehrzahl von zumindest vier Transfer-Gates in Form von MOS-Kondensatoren auf, um die erzeugten Ladungsträger aus dem photoaktiven Bereich zu transportieren, sowie eine Steuerschaltung, die ausgebildet ist, um zyklisch, in jedem Zyklus ein erstes der zumindest drei Transfer-Gates während eines mit einem Strahlungspuls einer Strahlungsquelle synchronisierten ersten Ansteuerintervalls anzusteuern, so dass während des ersten Ansteuerintervalls erzeugte erste Ladungsträger von dem photoaktiven Bereich zu einer ersten Auswertekapazität transportiert werden können, um ein zweites der zumindest drei Transfer-Gates während eines mit einem Strahlungspuls einer Strahlungsquelle synchronisierten außerhalb des ersten Ansteuerungsintervalls liegenden zweiten Ansteuerintervalls anzusteuern, so dass während des zweiten Ansteuerintervalls erzeugte zweite Ladungsträger von dem photoaktiven Bereich zu einer zweiten Auswertekapazität transportiert werden können, um ein drittes der zumindest drei Transfer-Gates während eines außerhalb des ersten und zweiten Ansteuerintervalls liegenden dritten Ansteuerintervalls anzusteuern, so dass während des dritten Ansteuerintervalls erzeugte dritte Ladungsträger von dem photoaktiven Bereich zu einer dritten Auswertekapazität transportiert werden können, und um das weitere der vier Transfer-Gates während einer Zeit außerhalb des ersten, zweiten und dritten Ansteuerintervalls durchgängig anzusteuern, um den photoaktiven Bereich mit dem Referenzpotentialanschluss zu verbinden, so dass zu jedem Zeitpunkt während des Zyklus zumindest eines der Mehrzahl der Transfer-Gates angesteuert wird. Vier Auswertekapazitäten in Form von Floatingdiffusion-Bereichen, sind lateral beabstandet von einer Kante des photoaktiven Bereichs um den photoaktiven Bereich herum angeordnet. Die vier Transfer-Gates sind ausgebildet, um die erzeugten Ladungsträger aus dem photoaktiven Bereich zu einer jeweiligen der zumindest vier Auswertekapazitäten zu transportieren, wobei die Steuerschaltung ausgebildet ist, um von einem Zyklus zu einem darauffolgenden Zyklus die Ansteuerung der Transfergates zu ändern, so dass eine vierte der vier Auswertekapazitäten, zu dem die erzeugten Ladungsträger aus dem photoaktiven Bereich durch das weitere der vier Transfer-Gates transportierbar sind, zur Ladungsträgerakkumulation während des ersten Ansteuerintervalls verwendet wird.

Gemäß einem weiteren Ausführungsbeispiel stellt die vorliegende Erfindung ein System zur optischen Abstandsmessung mit einer Strahlungsquelle zum Aussenden eines Strahlungspulses in Richtung eines Messobjekts, einer erfindungsgemäßen Pixelstruktur und einer Synchronisationseinheit zum Synchronisieren der Strahlungsquelle mit der Steuerschaltung der Pixelstruktur bereit, so dass die Steuerschaltung die Transfer-Gates derart ansteuert, dass die Ansteuerintervalle der Transfer-Gates von dem Strahlungspuls abhängen.

Der photoaktive Bereich der Pixelstruktur kann gemäß verschiedener Ausführungsbeispiele durch eine gepinnte Photodiode, eine vergrabene (buried) Photodiode oder durch ein Photogate gebildet sein. Generell kann der photoaktive Bereich durch jegliche Art von Photodioden realisiert sein, die eine Möglichkeit des gezielten Ladungstransfers durch ein Steuergate bzw. Transfer-Gate aufweisen (z. B. Pixelstrukturen mit Lateral Drift-Field Photodioden). Somit kann die oben beschriebene elektronische "Shutter"-Funktionalität durch entsprechend gewählte Ansteuerintervalle direkt in der ToF-Pixelstruktur selbst integriert werden.

Jedes der Mehrzahl der Transfer-Gates bewirkt einen Transport von photogenerierten Ladungsträgern aus dem photoaktiven Bereich zu einem entsprechenden Ausleseknoten, der beispielsweise durch einen Floating-Diffusion Bereich mit einer Sperrschichtkapazität $C_{FD}$ gebildet wird. Dazu sind die Transfer-Gates gemäß einem bevorzugten Ausführungsbeispiel jeweils an unterschiedlichen Kanten bzw. Randbereichen des photoaktiven Bereichs gebildet. Mit Hilfe zweier Transfer-Gates und zweier als Auswertekapazitäten wirkender Floating-Diffusion Bereiche kann ein zurückreflektierter Strahlungs- bzw. Lichtpuls und dessen zeitliche Verschiebung $T_d$ zum ausgesendeten Strahlungs- bzw. Lichtpuls ermittelt werden. Zu allen anderen Zeitpunkten außerhalb der Ansteuerintervalle der wenigstens zwei Transfer-Gates kann durch Aktivierung eines weiteren Transfer-Gates der photoaktive Bereich mit einer Ladungsträgersenke verbunden werden und somit alle unerwünschten thermisch und durch Hintergrundlicht erzeugten Ladungsträger in Richtung der Ladungsträgersenke abfließen lassen. Gemäß einem bevorzugten Ausführungsbeispiel wird die Ladungsträgersenke durch einen Floating-Diffusion Bereich realisiert, der über einen Reset-Transistor zu allen anderen Zeitpunkten außerhalb der Ansteuerintervalle der wenigstens zwei anderen Transfer-Gates mit einem Referenzpotential verbunden ist.

Mit Hilfe zweier Transfer-Gates und zweier Floating-Diffusion Bereiche kann einerseits der zurückreflektierte Strahlungspuls und dessen Verschiebung zum ausgesendeten Strahlungspuls ermittelt werden. Da der zurückreflektierte Strahlungspuls vom Hintergrundlicht überlagert wird, kann mittels eines dritten Transfer-Gates zeitnah zum reflektierten Puls das Hintergrundlicht $E_{amb}$ aufgenommen und daraufhin dessen Einflüsse auf die Distanzmessung herausgerechnet werden. Das vierte Transfer-Gate dient zum "Absaugen" von durch Hintergrundlicht erzeugten Photoladungsträgern während der Zeiträume, in denen die anderen drei Transfer-Gates nicht aktiv sind. Dazu wird das vierte Transfer-Gate während aller Zeitpunkte außerhalb der Ansteuerintervalle der übrigen drei Transfer-Gates durchgängig angesteuert, um den photoaktiven Bereich während dieser Zeit über das vierte Transfer-Gate bzw. den Transfer-Transistor mit der Ladungsträgersenke zu verbinden.

Ausführungsbeispiele der vorliegenden Erfindung ermöglichen die Verwendung von nur einem Laserpuls zur kompletten Aufnahme der Zeitverzögerung $T_d$ des Pulses bzw. der daraus resultierenden Distanzinformation d. Dadurch kann eine benötigte Laserenergie im Vergleich zum Stand der Technik halbiert und gleichzeitig eine Messgeschwindigkeit verdoppelt werden. Hieraus folgt eine optimal mögliche Korrelation von Entfernungs- und Normierungsmesswerten (Reflektivität, abstandsbedingte Abschwächung), wodurch das erfindungsgemäße Konzept auch für zeitlich stark veränderliche Szenarien bzw. sehr schnell bewegte Objekte geeignet ist.

Bei einer Pixelstruktur gemäß einem Ausführungsbeispiel der vorliegenden Erfindung kann das Hintergrundlicht nahezu zeitgleich mit dem Signal aufgenommen werden und anschließend vom Nutzsignal subtrahiert werden, wodurch auch die Messgeschwindigkeit erhöht werden kann.

Durch eine Trennung von Detektions- und Ausleseknoten ist ein Reset- bzw. Rücksetz-Rauschen nicht mehr von dem photoaktiven Bereich abhängig und kann bei klein gewählten Floating-Diffusions somit deutlich reduziert werden. Dieser Vorteil kommt speziell beim Einsatz von großflächigen Photoaktivgebieten und gleichzeitig klein dimensionierten Ausleseknoten zum Tragen.

Eine erfindungsgemäße ToF-Pixelstruktur bietet durch N-faches Aussenden des Strahlungspulses ebenfalls die Möglichkeit zur N-fachen Ladungsträgerakkumulation bereits innerhalb der Floating-Diffusions der Pixelstruktur. Hierdurch kann der Betrag des Rücksetz- bzw. Reset-Rauschens minimiert und ein Dynamikbereich sowie ein Signal-zu-Rausch-Leistungsverhältnis erhöht werden.

Bevorzugte Ausführungsbeispiele der vorliegenden Erfindung werden nun nachfolgend bezugnehmend auf die beiliegenden Zeichnungen näher erläutert. Es zeigen:

Fig. 1      eine schematische Darstellung eines herkömmlichen Systems zur optischen Abstandsmessung gemäß dem ToF-Prinzip;

Fig. 2      eine halbschematische Querschnittsdarstellung einer herkömmlichen ToF-Pixelstruktur basierend auf einer Pinned-Photodiode;

Fig. 3      eine halbschematische Querschnittsdarstellung einer herkömmlichen ToF-Pixelstruktur basierend auf einem Photogate;

Fig. 4    eine schematische Draufsichtsdarstellung einer Pixelstruktur gemäß einem Ausführungsbeispiel der vorliegenden Erfindung;

Fig. 5    eine Querschnittsdarstellung der Pixelstruktur gemäß Fig. 4;

Fig. 6    eine Darstellung eines analogen Signalpfads eines erfindungsgemäßen ToF-Pixels mit vier Floating-Diffusion-Ausleseknoten und zugehöriger CDS-Stufe;

Fig. 7    eine schematische Querschnittsdarstellung einer Photogate-basierten ToF-Pixelstruktur gemäß einem Ausführungsbeispiel der vorliegenden Erfindung; und

Fig. 8    eine schematische Darstellung eines zeitlichen Ablaufs von Ansteuersignalen zur Steuerung einer erfindungsgemäßen Pixelstruktur.

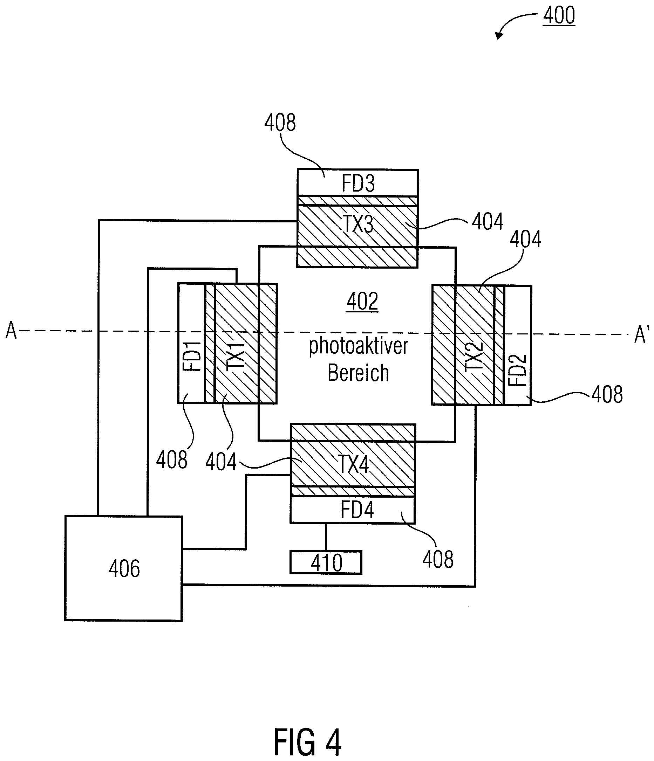

Bevor im Folgenden die vorliegende Erfindung anhand der Fig. 4 bis 7 näher erläutert wird, wird darauf hingewiesen, dass gleiche Elemente in den Figuren mit den gleichen oder ähnlichen Bezugszeichen versehen sind und dass eine wiederholte Beschreibung dieser Elemente weggelassen wird.

Ferner wird darauf hingewiesen, dass bei der folgenden Figurenbeschreibung davon ausgegangen wird, dass die gezeigten Pixelstrukturen Teil eines Systems zur optischen Abstandsmessung ähnlich zu Fig. 1 sind, weshalb teilweise auf Fig. 1 und deren Elemente Bezug genommen wird, ohne den Aufbau von Fig. 1 erneut zu beschreiben. Insbesondere stellen die nachfolgend beschriebenen Pixelstrukturen beispielsweise ein einzelnes Pixel eines Pixelarrays eines Bildsensors 106 dar, wie es aus der folgenden Beschreibung noch näher hervorgehen wird.

Fig. 4 zeigt in einer schematischen Draufsichtsdarstellung eine Pixelstruktur 400 gemäß einem Ausführungsbeispiel der vorliegenden Erfindung.

Die Pixelstruktur 400 weist einen photoaktiven bzw. photoempfindlichen Bereich 402 auf zur Erzeugung von Ladungsträgern ansprechend auf optische Strahlung, die auf den photoaktiven Bereich 402 fällt. Ferner ist eine Mehrzahl von Transfer-Gates 404-n bzw. TXn (n=1,2,...) vorgesehen, um die erzeugten Ladungsträger aus dem photoaktiven Bereich 402 zu transportieren. Eine Steuerschaltung 406 ist vorgesehen, um wenigstens zwei unterschiedliche 404-1, 404-2 der Mehrzahl der Transfer-Gates, während unterschiedlicher periodischer Ansteuerintervalle anzusteuern, so dass während der Ansteuerintervalle durch einen von einem Messobjekt 104 reflektierten Strahlungspuls und/oder durch Hintergrundstrahlung erzeugte Ladungsträger von dem photoaktiven Bereich 402 zu jeweils mit den wenigstens zwei Transfer-Gates 404-1, 404-2 gekoppelten Ausleseknoten bzw. Auswertekapazitäten 408-n bzw. FDn (n=1,2,...) transportiert werden können. Die Steuerschaltung 406 ist ferner ausgebildet, um ein weiteres Transfer-Gate 404-4 der Mehrzahl von Transfer-Gates 404-n (n=1,2,...) während einer Zeit außerhalb der Ansteuerintervalle der anderen Transfer-Gates 404-1, 404-2 (und/oder 404-3) dauerhaft anzusteuern, um den photoaktiven Bereich 402 während der ganzen Zeit außerhalb der Ansteuerintervalle der anderen Transfer-Gates mit einer Ladungsträgersenke 410 zu verbinden. Bei der Ladungsträgersenke 410 handelt es sich dabei gemäß Ausführungsbeispielen um ein Referenzpotential bzw. einen Referenzpotentialanschluss, der das Transfer-Gate 404-4 mit dem Referenzpotential koppelt, wobei sich das Referenzpotential in für Halbleiterschaltungen typischen Bereichen bewegen kann, d.h. von ca. 1V bis ca. 5 V.

In anderen Worten ausgedrückt, umfasst eine erfindungsgemäße Pixelstruktur 400 also wenigstens drei Transfer-Gates 404-n bzw. TXn, wobei wenigstens zwei zum Transport von photogenerierten Ladungsträgern aus dem photoaktiven Bereich 402 zu entsprechenden Auswerteknoten bzw. -kapazitäten 408-n bzw. FDn dienen, und wobei eines der Transfer-Gates 404-4 zu allen Zeitpunkten, an denen die anderen Transfer-Gates inaktiv sind, für einen Ladungsträgertransport aus dem photoaktiven Bereich 402 hin zu der Ladungsträgersenke 410 dient, um nicht gewollte Ladungsträger, die die Messung verfälschen, aus dem photoaktiven Bereich 402 abfließen zu lassen.

Obwohl für die vorliegende Erfindung also bereits drei Transfer- bzw. Steuer-Gates als ausreichend sind, zeigt Fig. 4 ein bevorzugtes Ausführungsbeispiel eines Pixelsensors mit vier Transfer-Gates 404-n (n=1,...,4), die an unterschiedlichen Randbereichen des photoaktiven Bereichs 402 gebildet sind. Der photoaktive Bereich 402 kann dabei gemäß unterschiedlichen Ausführungsbeispielen einen pn-Übergang als photoempfindliches Bauelement, eine PIN-Photodiode, eine gepinnte Photodiode oder ein Photogate umfassen, die teilweise bereits anhand der Fig. 2 und 3 beschrieben wurden. Der photoaktive Bereich 402, der sich im Zentrum der aktiven Pixelstruktur 400 befinden kann, ist in Fig. 4 beispielhaft quadratisch dargestellt, kann aber durchaus zur Verbesserung physikalischer Transporteigenschaften auch aus Polygonen mit mehr als vier Ecken bestehen. An vier Kanten bzw. Randbereichen des photoaktiven Bereichs 402 befinden sich Transfer-Gates 404-n (n=1,...,4), die einen Transport photogenerierter Ladungsträger aus dem photoaktiven Bereich 402 zum jeweiligen Ausleseknoten 408-n bzw., im Fall des Transfer-Gates 404-4, den Transport photogenerierter Ladungsträger zur Ladungsträgersenke 410 hin ermöglichen. Mit Hilfe der zwei Transfer-Gates 404-1 und 404-2 und der durch die zwei entsprechenden Floating-Diffusions FD1 und FD2 gebildeten Auslesekapazitäten 408-1 und 408-2 kann einerseits ein zurückreflektierter Strahlungspuls und dessen zeitliche Verschiebung $T_d$ zum ausgesendeten Strahlungspuls ermittelt werden. Anderseits bieten die beiden weiteren Transfer-Gates 404-3 und 404-4 und die durch die zwei entsprechenden Floating-Diffusions FD3 und FD4 gebildeten Auslesekapazitäten 408-3 und 408-4 die Möglichkeit, das Hintergrundlicht aufzunehmen und in gewünschten Taktzyklen effektiv zu unterdrücken, wie es unten noch detailliert erläutert wird. Zur kompletten Aufnahme der Zeitverzögerung $T_d$ des reflektierten Strahlungspulses bzw. der Distanzinformation d ist dabei nur ein ausgesendeter Strahlungspuls notwendig.

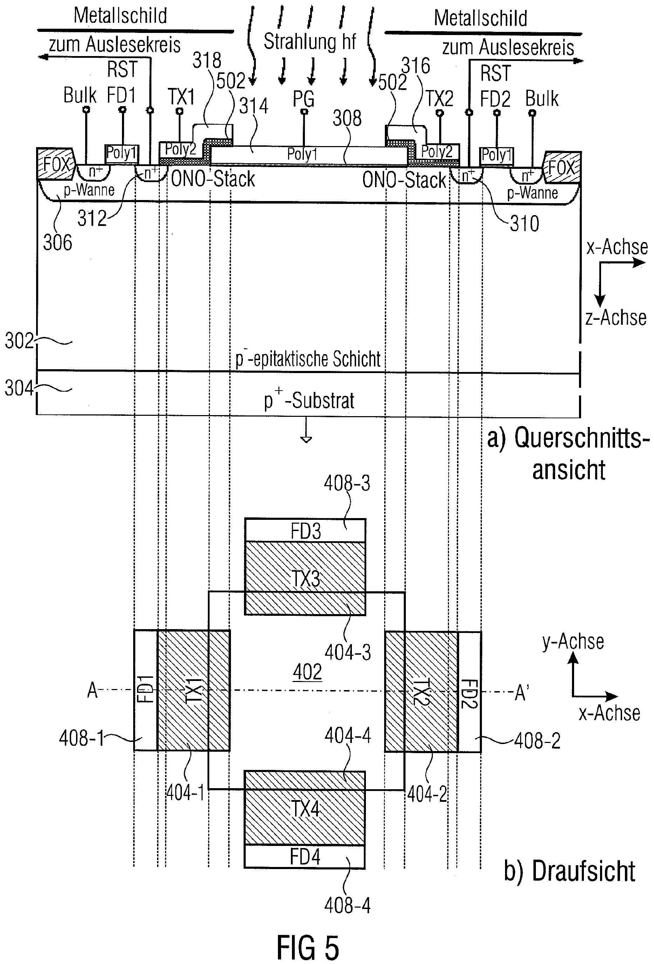

Nachdem anhand der in Fig. 4 gezeigten Draufsicht eine erfindungsgemäße Pixelstruktur grob beschrieben wurde, zeigt Fig. 5 einen detaillierteren Querschnitt der Pixelstruktur 400 entlang der Schnittlinie AA'.

Dabei wird ein Aufbau erkennbar, der dem bereits anhand der Fig. 3 beschriebenen ähnelt. Die Pixelstruktur 400 kann in einem Standard CMOS-Prozess auf einem $p^+$-Substrat und einer $p^-$-epi-Schicht 302 integriert werden. Der photoaktive Bereich 402 bzw. das Photogate PG wird durch einen MOS-Kondensator aus einem Schichtstapel aus einer ersten Polysiliziumschicht 314 (Poly 1) auf einem dünnen Siliziumoxid 308 auf einer p-Wanne 306 definiert. Für den Transfer von photogenerierten Ladungsträgern aus dem photoaktiven Bereich 402 werden zweite MOS-Kondensatoren als Transfer-Gates 404-n benutzt, die jeweils durch einen Schichtstapel aus einer zweiten Polysiliziumschicht (Poly 2) auf einer Oxid-Nitrid-Oxid (ONO)-Isolationsschicht 502 auf der p-Wanne 306 definiert sind. Dabei überlappt die Poly-2-Schicht 316, 318 und die jeweilige ONO-Schicht 502 der Transfer-Gates 404-n jeweils teilweise mit der Poly-1-Schicht 314 des Photogates PG. Die vier Poly-2-MOS-Kondensatoren bilden dabei also die vier Transfer-Gates 404-n, die an vier Kanten mit dem beispielsweise quadratischen Photogate PG überlappen und den Ladungstransfer zwischen dem Photogate PG und den $n^+$-Diffusionsbereichen 310, 312 (Floating-Diffusions FDn) ermöglichen. Jede der Floating-Diffusions FDn (n=1,...,4) ist mit einem Rücksetz- bzw. Resettransistor und einem Auslesekreis (nicht gezeigt) gekoppelt, wie es im Nachfolgenden noch beschrieben wird.

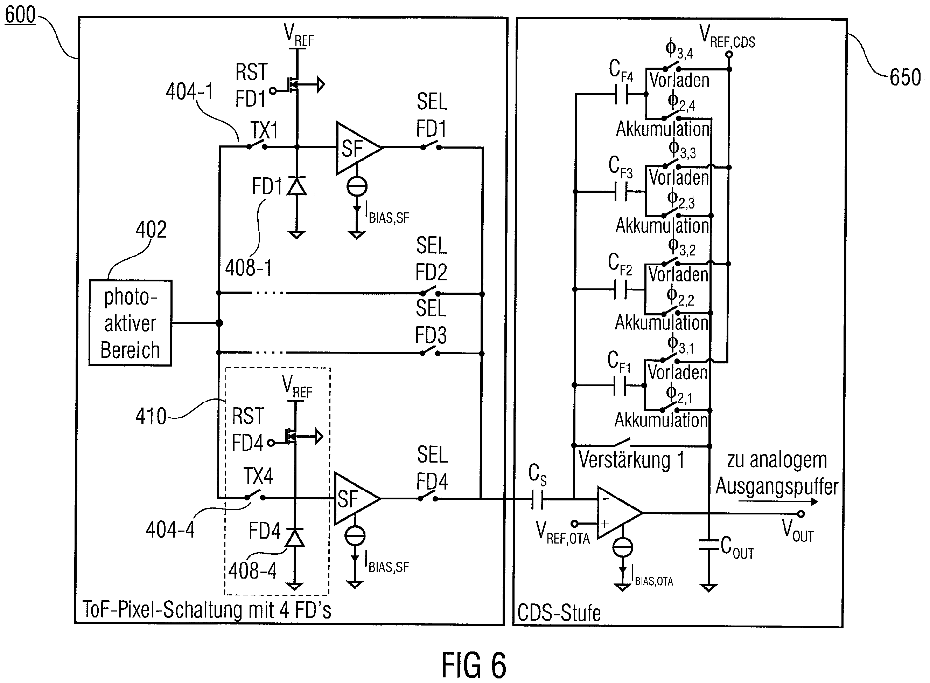

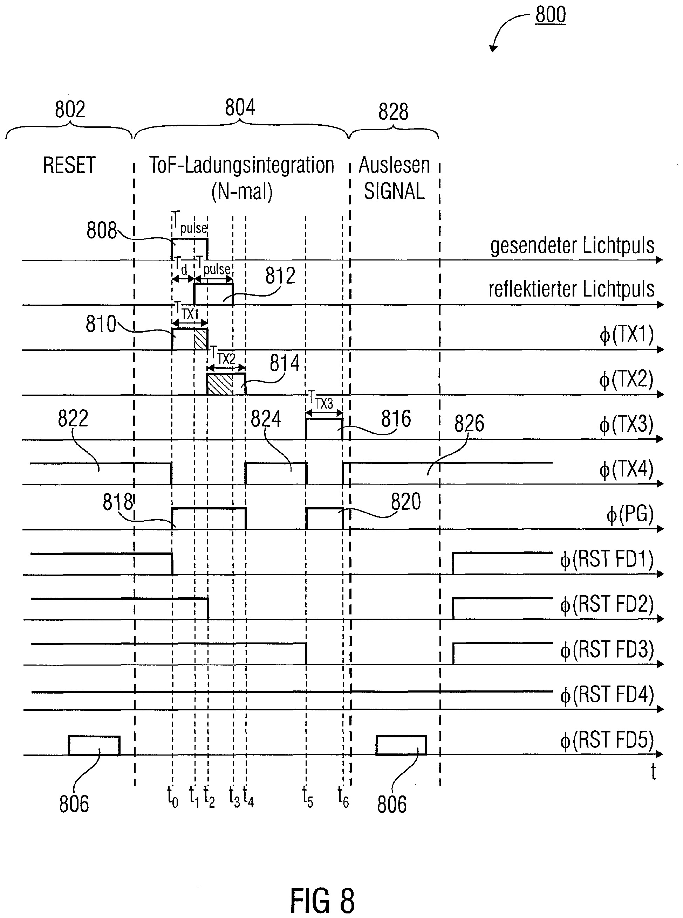

Nachdem im Vorhergehenden ein exemplarischer Aufbau einer erfindungsgemäßen Pixelstruktur 400 erläutert wurde, soll im Folgenden die Funktionsweise eines darauf basierenden Active-Pixel-Sensors anhand einer Schaltung (Fig. 6) für ein APS und einem dazugehörigen Zeitdiagramm (Fig. 8), mit dem eine Messung zur Entfernung d mit Störlichtkorrektur veranschaulicht wird, dargestellt werden.

Fig. 6 zeigt einen schematischen Aufbau einer Laufzeit-Analog-Ausleseschaltung 600 für die Pixelstruktur 400. Dabei umfasst die Ausleseschaltung 600 für jedes der vier Transfer-Gates TXn bzw. 404-n (n=1,...,4) jeweils einen Auslesepfad. Die durch die Floating-Diffusions FDn (n=1,...,4) gebildeten Auslesekapazitäten 408-n werden zu Beginn jedes Belichtungsvorgangs jeweils über einen Rücksetz- bzw. Reset-Schalter RST FDn (n=1,...,4), der als Transistor ausgebildet sein kann, mit einem Referenzpotential $V_{REF}$ vorgespannt. Jeder der vier Auslesepfade weist außerdem jeweils einen Pufferverstärker SF auf. Die Pufferverstärker SF sind in der Regel als Sourcefolger ausgeführt und puffern die über den Sperrschichtkapazitäten der Floating-Diffusions FDn (n=1,...,4) anliegenden Spannungen ab. Die Ausgänge der Pufferverstärker SF sind jeweils über einen Auswahl- bzw. Selectschalter SEL FDn (n=1,...,4) mit einer sich anschließenden Schaltung 650 zur korrelierten Doppelabtastung (CDS = Correlated Double Sampling) verbindbar.

Die Weiterverarbeitung der angesammelten Ladungspakete der einzelnen Floating-Diffusions FDn (n=1,...,4) wird also, wie in Fig. 6 dargestellt, mit typischen Active-Pixel-Ausleseschaltungen, jeweils bestehend aus drei Transistoren und einer nachgeschalteten CDS-Stufe 650 realisiert. An jedem der vier Ausleseknoten FDn (n=1,...,4) ist ein Reset-Transistor RST FDn (n=1,...,4) angeschlossen, mit dessen Hilfe die Sperrschichtkapazität der jeweiligen Floating-Diffusion FDn (n=1,...,4) während der Reset-Phase auf ein Referenzpotential $V_{REF}$ vorgespannt wird. Innerhalb der Ladungsträgertransferphase und bei abgeschaltetem Reset, wird die jeweilige Sperrschichtkapazität 408-n (n=1,...,4) in Abhängigkeit der transferierten Ladungsträger wieder entladen. Das an den vier Floating-Diffusions FDn (n=1,...,4) jeweils anliegende Messsignal wird mit vier separaten Source-Folgern SF gepuffert und mit Select-Schaltern SEL FDn (n=1,...,4) auf den Eingang der CDS-Stufe 650 geschaltet. Die CDS-Stufe 650 weist vier Feedbackstufen auf, mit deren Hilfe sich außerhalb der eigentlichen APS-Pixelstruktur eine zusätzliche N-fach Akkumulation für jede der vier Floating-Diffusions FDn (n=1,...,4) realisieren lässt. Zudem können mit der CDS-Stufe 650 niederfrequente Rauschanteile des Analogpfads 600 eliminiert werden.

Die Ladungsträgersenke 410 wird gemäß einem Ausführungsbeispiel dadurch gebildet, dass die durch die vierte Floating-Diffusion FD4 gebildete Auswertekapazität 408-4 über den Reset-Schalter bzw. -transistor RST FD4 mit dem Referenzpotential $V_{REF}$ verbunden ist, über das photogenerierte Ladungsträger abfließen können. D.h., die Ladungsträgersenke 410 wird durch den mit dem Referenzpotential $V_{REF}$ gekoppelten Floating-Diffusion-Bereich 408-4 bzw. FD4, der dem Transfer-Gate 404-4 bzw. TX4 zugeordnet ist, gebildet, so dass während der ganzen Zeit außerhalb der Ansteuerintervalle der anderen Transfer-Gates TX1, TX2, TX3 Ladungsträger aus dem photoaktiven Bereich 402 über das Transfer-Gate TX4 in Richtung des Referenzpotentials $V_{REF}$ abfließen können. Natürlich könnte der sich im Dauer-Reset-Zustand befindliche Transistor RST FD4 auch ganz weggelassen werden, so dass in diesem Fall die vierte Auswertekapazität 408-4 direkt mit dem Referenzpotential $V_{REF}$ verbunden werden könnte, um die Ladungsträgersenke zu bilden. Entsprechend könnte die der vierten Floating-Diffusion FD4 folgende Auswerteschaltung mit Pufferverstärker SF, Auswahlschalter SEL FD4 und der entsprechende Zweig in der CDS-Stufe 650 weggelassen werden. Es kann jedoch zweckmäßig sein, die vier unterschiedlichen Floating-Diffusions FDn (n=1,...,4) zufällig oder nach einem vorgegebenen Schema unterschiedlich anzusteuern. So könnte beispielsweise in einem ersten Messzyklus eine Konfiguration der vier Floating-Diffusions verwendet werden, wie sie im Vorhergehenden beschrieben wurde. In einem darauffolgenden Messzyklus könnte aber beispielsweise FD4 zur Ladungsträgerakkumulation während des ersten Ansteuerintervalls verwendet werden und, statt dessen, FD1 zum Absaugen photogenerierter Ladungsträger außerhalb der Ansteuerintervalle der übrigen Transfer-Gates TXn (n=2,3,4), so dass FD4 die Funktion die FD1, und umgekehrt, übernehmen würde. Durch diese Vorgehensweise können beispielsweise Herstellungstoleranzen bzgl. der Kapazitätswerte der Sperrschichtkapazitäten der Floating-Diffusions FDn (n=1,...,4) ausgeglichen werden.

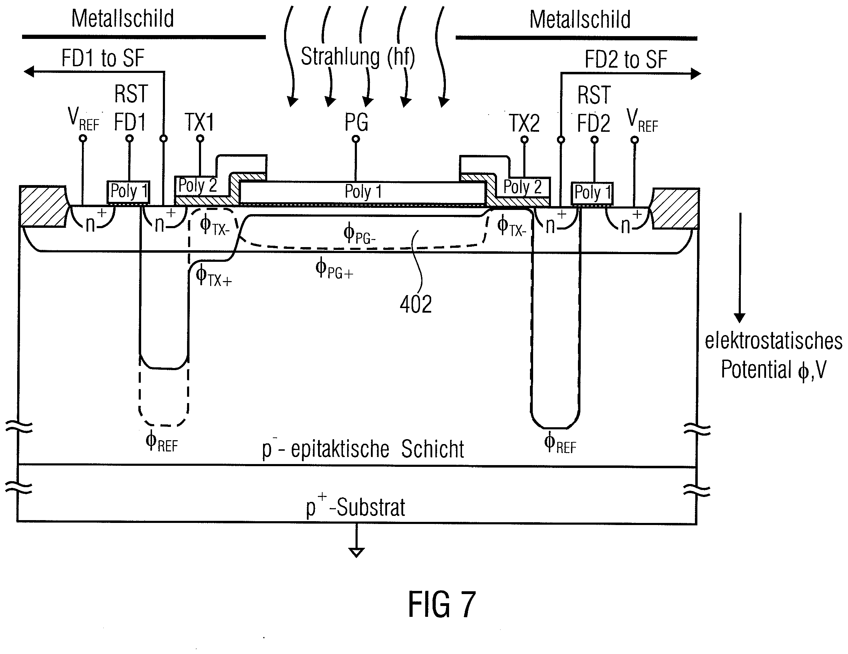

Anhand der Fig. 7 und 8 wird nun exemplarisch ein Auslesekonzept der erfindungsgemäßen ToF-Pixelstruktur 400 verdeutlicht und eine Arithmetik zur Bestimmung der Distanzinformation d bei gleichzeitiger Unterdrückung des Hintergrundlichts $E_{amb}$ beschrieben. Hierzu wird das in Fig. 7 im Querschnitt entlang der Linie AA' gezeigte Photogate-basierte ToF-Pixel 400, bestehend aus dem Photogate PG, vier Transfer-Gates TXn, vier Floating-Diffusions FDn und den zugehörigen Reset-Transistoren RST FDn (n=1,...,4) verwendet. Darüber hinaus sind in Fig. 7 Potentialverläufe innerhalb des Halbleitermaterials für eine Integrations-, Reset- und Transferphase dargestellt. Während einer Reset-Phase einer Floating-Diffusion FDn (n=1,...,4) ist das zugehörige Transfer-Gate 404-n bzw. TXn (n=1,...,4) ausgeschaltet ($\Phi_{TX-}$), d. h., der in Fig. 6 dargestellte entsprechende Schalter TXn (n=1,...,4) ist geöffnet. Während dieser Phase stellt sich an der entsprechenden Floating-Diffusion FDn (n=1,...,4) bzw. an deren Sperrschichtkapazität das Referenzpotential $\Phi_{REF}$ bzw. $V_{REF}$ ein. Bereits während der Reset-Phase ist es möglich, eine Ansammlung (Integration) photogenerierter Ladungsträger unterhalb des Photogates PG zu beginnen, indem eine Raumladungszone durch Vorspannen der Photogate-Elektrode ($\Phi_{PG+}$) erzeugt wird. Ein Transfervorgang von photogenerierten Ladungsträgern aus dem photoaktiven Bereich 402 über die Transfer-Gates 404-n bzw. TXn (n=1,...,4) zu den Floating-Diffusions 408-n bzw. FDn (n=1,...,4) kann nur dann stattfinden, wenn folgende Bedingungen für die elektrostatischen Potentiale innerhalb des Siliziums erfüllt sind:

$$\phi_{TX}^+ > \phi_{PG}^+ > \phi_{PG}^- > \phi_{TX}^- \qquad (2)$$

Betrachtet man die in Fig. 7 eingezeichneten Potentialverläufe, so erkennt man, dass bei vorgespannter Photogate-Elektrode ($\Phi_{PG+}$) und angesteuertem Transfer-Gate TX1 ($\Phi_{TX1+}$) ein Potentialgefälle in Richtung der durch die erste Floating-Diffusion FD1 gebildete erste Auslesekapazität 404-1 vorherrscht, so dass die Ladungsträger aus dem photoaktiven Bereich 402 unterhalb des Photogates PG hin zu der Floating-Diffsion FD1 transportiert werden können. Ein Ladungstransport aus dem photoaktiven Bereich 402 hin zu der zweiten Floating-Diffusion FD2 bei nicht angesteuerten zweiten Transfer-Gate TX2 ($\Phi_{TX-}$) ist jedoch nicht möglich. Wird hingegen TX2 angesteuert ($\Phi_{TX2+}$) und TX1 nicht angesteuert ($\Phi_{TX1-}$), verhält es sich umgekehrt, d.h. Ladungsträger werden aus dem photoaktiven Bereich 402 hin zur zweiten Floating-Diffusion FD2 transportiert. Gleiches gilt für die übrigen Transfer-Gates TXn bzw. 404-n (n=3,4) und die entsprechenden Floating-Diffusions.

Der zeitliche Ablauf einer ToF-Messung mit einer erfindungsgemäßen Pixelstruktur 400 wird nun anhand eines in Fig. 8 dargestellten Zeitablauf-Diagramms 800 näher erläutert.

Fig. 8 zeigt Potentialverläufe sowohl für die vier Transfer-Gates TXn (n=1,...,4) als auch für das Photogate PG aufgetragen über der Zeit t in willkürlichen Einheiten. Ebenso dargestellt sind Potentialverläufe für die Reset-Transistoren RST FDn (n=1,...,4) und die Auswahlschalter SEL FDn (n=1,...,4). Die Zeitachse wird grob unterteilt in drei Phasen: Rücksetz- bzw. Reset-Phase, Ladungsintegrationsphase und Auslesephase.

In der Reset-Phase 802 sind sämtliche Floating-Diffusions FDn (n=1,...,4) über ihre jeweils zugeordneten Reset-Transistoren RST FDn (n=1,...,4) auf das Referenzpotential ($\Phi_{REF}$) vorgespannt, weshalb sich Ansteuerpotentiale $\Phi$(RST FDn) der Reset-Transistoren in einem "High"-Zustand befinden. In dieser Reset-Phase 802 werden weder die Transfer-Gates TXn (n=1,...,4) noch das Photogate PG von der Steuerschaltung 406 angesteuert, was bedeutet, dass die in Fig. 6 gezeigten Schalter TXn (n=1,...,4) sämtlich geöffnet sind und sich unterhalb der Photogate-Elektrode 314 keine Raumladungszone ausbildet. In der Reset-Phase 802, d.h., vor einem ToF-Integrationszyklus 804, werden die vier Floating-Diffusions FDn (n=1,...,4) zurückgesetzt und das Reset-Level ($\Phi_{REF}$) als Referenz in der CDS-Stufe 650 gespeichert, weshalb in der Reset-Phase 802 die Auswahl-Schalter SEL FDn (n=1,...,4) jeweils angesteuert bzw. geschlossen werden, wie es durch Bezugszeichen 806 angedeutet ist.

In der ToF-Integrationsphase 804 wird zu einem Zeitpunkt $t_0$ ein optischer Strahlungspuls mit Pulsdauer $T_{pulse}$ emittiert (808) und zeitgleich das erste "Shutter"-Fenster durch Ansteuern des ersten Transfer-Gates TX1 in einem ersten Ansteuerintervall 810 aktiviert. Dabei ist das erste Ansteuerintervall 810 zeitlich zu dem gesendeten Puls 808 synchronisiert. D.h., das erste Ansteuerintervall 810 des ersten Transfer-Gates TX1 erstreckt sich vom Zeitpunkt $t_0$ über eine Dauer $T_{pulse}$ bis zum Zeitpunkt $t_2$. Je nach zeitlicher Verzögerung $T_d$ eines zurückreflektierten Strahlungspulses 812 befindet sich in der ersten Floating-Diffusion FD1 bzw. deren Sperrschichtkapazität zum Zeitpunkt $t_2$ ein Ladungspaket $Q_{FD1}$ gemäß

$$Q_{FD1} = r(I_{amb} \cdot T_{pulse} + I_{pulse} \cdot (T_{pulse} - T_d)) \tag{3}$$

Hierbei wird während des gesamten ersten Ansteuerintervalls 810, d.h. der Pulsdauer $T_{pulse}$, ein Photostrom $I_{amb}$ durch das Hintergrundlicht $E_{amb}$ erzeugt, wobei im Zeitfenster $T_{pulse} - T_d$, d.h. $t_1$ bis $t_2$, der Strom $I_{amb}$ durch einen Anteil $I_{pulse}$ des reflektierten Strahlungspulses 812 überlagert wird. Direkt bzw. unmittelbar nach dem ersten Ansteuerintervall $T_{TX1}$ 810, d.h., nach Abschalten des ersten Shutters, wird in einem zweiten Ansteuerintervall $T_{TX2}$ 814 ($t_2$ - $t_4$) durch Ansteuern des zweiten Transfer-Gates TX2 der zweite "Shutter" aktiv und nimmt den restlichen Anteil des reflektierten Strahlungspulses 812 auf. Das zweite Ansteuerintervall 814 entspricht gemäß einem bevorzugten Ausführungs-beispiel ebenfalls der Pulsdauer $T_{pulse}$, so dass in einem Zeitfenster von $t_2$ bis $t_3$, das der Verzögerungszeit $T_d$ entspricht, der Photostrom $I_{amb}$ durch das Hintergrundlicht $E_{amb}$ von einem Anteil $I_{pulse}$ des reflektierten Strahlungspulses 812 überlagert wird. In der zweiten Floating-Diffusion FD2 bzw. deren Sperrschichtkapazität ist somit nach Beendigung des zweiten Ansteuerintervalls $T_{TX2}$ das Ladungspaket $Q_{FD2}$ gemäß

$$Q_{FD2} = r(I_{amb} \cdot T_{pulse} + I_{pulse} \cdot T_d) \tag{4}$$

enthalten. Zur Bestimmung des Hintergrundlichtanteils wird nach einer gewissen Totzeit, entsprechend dem Zeitintervall $t_4$ bis $t_5$ (816), das dritte Transfer-Gate TX3 für eine Zeit $T_{TX3} = T_{pulse}$ angesteuert und das resultierende Ladungspaket $Q_{FD3}$ in der dritten Floating-Diffusion FD3 bzw. deren Sperrschichtkapazität gespeichert.

$$Q_{FD3} = r(I_{amb} \cdot T_{pulse}) \tag{5}$$

Während der Ansteuerintervalle $T_{TX1}$, $T_{TX2}$ und $T_{TX3}$ der drei Transfer-Gates TXn (n=1,2,3) wird zudem das Photogate PG positiv vorgespannt, um eine Raumladungszone im Bereich des photoaktiven Bereichs 402 zu erzeugen. Dies ist durch die Bezugszeichen 818 und 820 angedeutet. Zu allen anderen Zeitpunkten t wird diese Raumladungszone auf eine minimale, oberflächennahe Ausdehnung reduziert und das vierte Transfer-Gate TX4 angesteuert, was durch die Bezugszeichen 822, 824 und 826 angedeutet ist. Die vierte Floating-Diffusion FD4 bzw. deren Sperrschichtkapazität befindet sich dabei während der Zeiträume 822, 824 und 826 also quasi in einem Dauer-Reset-Zustand und lässt alle unerwünschten thermisch und durch Hintergrundlicht erzeugten Ladungsträger in Richtung des Referenzpotentials ($\Phi_{REF}$) fließen.

Wie sich aus dem Zeitablaufdiagramm der Fig. 8 erkennen lässt, ist die Steuerschaltung 406 also ausgebildet, um die der Mehrzahl der Transfer-Gates TXn innerhalb eines Ladungsintegrationszyklus zyklisch anzusteuern. In jedem Ladungsintegrationszyklus werden die wenigstens zwei der Mehrzahl der Transfer-Gates TXn jeweils wenigstens einmal angesteuert, so dass während der Ansteuerintervalle 810, 814, 816 erzeugte Ladungsträger von dem photoaktiven Bereich 402 zu jeweils mit den wenigstens zwei Transfer-Gates gekoppelten Auswertekapazitäten 408 transportiert werden können. Außerdem wird während der Ansteuerintervalle 810, 814, 816 der wenigstens zwei Transfer-Gates das weitere Transfer-Gate 404-4 bzw. TX4 nicht angesteuert, so dass der photoaktive Bereich 402 während Ansteuerintervalle der wenigstens zwei Transfer-Gates nicht mit dem Referenzpotentialanschluss verbunden ist. Des Weiteren wird in jedem Zyklus das weitere Transfer-Gate 404-4 bzw. TX4 wenigstens einmal während einer Zeit 822, 824, 826 außerhalb der Ansteuerintervalle 810, 814, 816 der wenigstens zwei Transfer-Gates angesteuert, um den photoaktiven Bereich 402 über das weitere Transfer-Gate 404-4 bzw. TX4 mit dem Referenzpotentialanschluss zu verbinden. D.h., zu jedem Zeitpunkt während des Zyklus wird zumindest eines der Mehrzahl der Transfer-Gates 404-n bzw. TXn (n=1,...,4) angesteuert.

Die Steuerschaltung 406 ist gemäß einem bevorzugten Ausführungsbeispiel der vorliegenden Erfindung ausgebildet, um das erste Transfer-Gate TX1 während des mit dem Strahlungspuls 808 einer Strahlungsquelle synchronisierten ersten Ansteuerintervalls 810 anzusteuern, so dass während des ersten Ansteuerintervalls 810 erzeugte erste Ladungsträger von dem photoaktiven Bereich 402 zu einer durch die erste Floating-Diffusion FD1 gebildeten ersten Auswertekapazität 408-1 transportiert werden können. Ferner ist die Steuerschaltung 406 ausgebildet, um ein zweites Transfer-Gate TX2 während eines sich unmittelbar an das erste Ansteuerintervall 810 anschließenden zweiten Ansteuerintervalls 814 anzusteuern, so dass während des zweiten Ansteuerintervalls 814 erzeugte zweite Ladungsträger von dem photoaktiven Bereich 402 zu einer durch die zweite Floating-Diffusion-FD2 gebildeten Auswertekapazität 408-2 transportiert werden können. Die Steuerschaltung 406 ist zudem ausgebildet, um ein drittes Transfer-Gate TX3 während eines außerhalb des ersten und zweiten Ansteuerintervalls 810, 814 liegenden dritten Ansteuerintervalls 816 anzusteuern, so dass während des dritten Ansteuerintervalls 816 erzeugte dritte Ladungsträger von dem photoaktiven Bereich 402 zu einer durch die dritte Floating-Diffusion FD3 gebildeten dritten Auswertekapazität 408-3 transportiert werden können. Die Steuerschaltung 406 steuert das vierte Transfer-Gate TX4 während allen anderen Zeitpunkten außerhalb des ersten, zweiten und dritten Steuerintervalls 810, 814, 816 an, um den photoaktiven Bereich 402 mit der Ladungsträgersenke 410 zu verbinden.

Dabei ist die Dauer $T_{TXn} = T_{pulse}$ (n=1,...,4) der in Fig. 8 gezeigten Ansteuerintervalle 810, 814, 816 nicht zwingend. Genau so gut könnte die Steuerschaltung 406 ausgebildet sein, um die vier Transfer-Gates TXn (n=1,...,4) derart anzusteuern, so dass das erste, zweite und dritte Ansteuerintervall 810, 814, 816 jeweils einem Vielfachen einer Pulsdauer $T_{pulse}$, abhängig von einer zu erwartenden Verzögerungszeit $T_d$ eine von dem Messobjekt 104 reflektierten Strahlungspulses, entsprechen. D.h., $T_{TXn} = i*T_{pulse}$ (n=1,...,4; i $\in$ IN$_0^+$).

Aus den Ladungspaketen $Q_{FD1}$, $Q_{FD2}$ und $Q_{FD3}$ bzw. daraus abgeleiteten Spannungen lässt sich nun die Zeitverzögerung $T_d$ bestimmen. Dazu ist die Active-Pixel-Struktur 400 mit einer Auswerteschaltung gekoppelt, die dazu zunächst die Hintergrundladung $Q_{FD3}$ von den beiden signal-beinhaltenden Ladungen $Q_{FD1}$ und $Q_{FD2}$ subtrahiert. Nach einigen Umformungen lässt sich die Zeitverzögerung $T_d$ gemäß

$$T_d = T_{pulse} \frac{Q_{FD2} - Q_{FD3}}{Q_{FD1} + Q_{FD2} - 2Q_{FD3}} \qquad (6)$$

ausdrücken, wobei sich die Reflektanz r des Messobjekts 104 herauskürzt. Unter Berücksichtigung von Gl. (1) ergibt sich die Messdistanz d zu

$$d = \frac{c}{2} T_d = \frac{c}{2} \frac{Q_{FD2} - Q_{FD3}}{Q_{FD1} + Q_{FD2} - 2Q_{FD3}} T_{pulse} \cdot \qquad (7)$$

Bei gleich groß gewählten Floating-Diffusion-Flächen und somit gleich großen Auslesekapazitäten 408 lässt sich die Distanz d wie folgt direkt aus an den Sperrschichtkapazitäten der Floating-Diffusions FDn (n=1,2,3) gemessenen Spannungen ermitteln:

$$d = \frac{c}{2} \frac{V_{FD2} - V_{VD3}}{V_{FD1} + V_{FD2} - 2V_{FD3}} T_{pulse} \cdot \qquad (8)$$

Eine Differenzbildung von Reset-Level $\Phi_{REF}$ und Signal-Werten der Floating-Diffusion-Spannungen, aus denen sich die Spannungen $V_{FDn}$ ergeben, findet in der CDS-Stufe 650 statt. Die Weiterverarbeitung von Berechnungen der Distanzwerte d kann entweder schaltungstechnisch "on-chip" oder per Software extern erfolgen.

Mit einem erfindungsgemäßen ToF-Pixel und dem zugehörigen Auslesekonzept kann ein 3D-Bildsensor mit einem Pixelarray von beispielsweise 4 x 16 Pixeln realisiert werden. Dabei können die erfindungsgemäßen Active-Pixel-Strukturen z. B. mittels eines Standard 0,35 $\mu$m CMOS-Prozesses hergestellt werden. Wird als Lichtquelle ein gepulster Nahinfra-rot-(NIR-) Laser (Wellenlänge $\lambda$ = 905 nm) mit Pulsbreiten von 30 ns $\leq T_{pulse} \leq$ 60 ns verwendet, so sind Distanzmessungen von bis zu d = 9 m möglich. Der Photogatebereich 402 kann beispielhaft eine Größe von 30 x 30 $\mu$m$^2$ aufweisen, die Transfer-Gates TXn (n=1,...,4) haben beispielsweise jeweils eine Länge von 3 $\mu$m und die Floating-Diffusion-Bereiche FDn (n=1,...,4) können z.B. in einem Bereich von 20 x 1,5 $\mu$m$^2$ bis zu 20 x 9 $\mu$m$^2$ variiert werden, was Sperrschichtkapazitäten ($C_{FD}$) in einem Bereich von 12 fF bis 72 fF für den Reset-Zustand ($\Phi_{FD} = \Phi_{REF}$ = 3,3 V) entspricht.

Erfindungsgemäße ToF-Pixelstrukturen und das zugehörige Auslesekonzept sind nicht nur auf Photogate-basierte APS beschränkt, wozu auch Pixelstrukturen zählen, die durch spezielle technologische und layout-bezogene Optimierungen die Transporteigenschaften der photogenerierten Ladungen verbessern. Diese Verbesserungen können beispielsweise durch oberflächennahe "Buried Channel"-Implantationen oder hochohmige Polysilizium-Gates erzielt worden sein. Vielmehr arbeitet das erfindungsgemäße Konzept auch mit Pinned oder Buried-Photodioden-basierten APS oder allgemein mit jeglicher Art von Photodioden-basierten APS, die die Möglichkeit des gezielten Ladungstransfers durch ein Steuer- bzw. Transfer-Gate besitzen, wie z. B. auch Pixelstrukturen mit Lateral Drift-Field-Photodioden.

Durch das Verwenden des erfindungsgemäßen Konzepts ist es möglich, durch die Verwendung von nur einem Laserpuls die Distanzmessung durchzuführen. Dadurch kann eine benötigte Laserenergie im Vergleich zum Stand der Technik halbiert und gleichzeitig die Messgeschwindigkeit verdoppelt werden. Hieraus folgt eine optimal mögliche Korrelation von Entfernungs- und Normierungsmesswerten (Reflektivität, abstandsbedingte Abschwächung), wodurch das erfindungsgemäße Konzept auch für zeitlich stark veränderliche Szenarien z. B. sehr schnell bewegte Messobjekte 104 geeignet ist.

Bereits innerhalb der Pixelstruktur 400 kann das Hintergrundlicht $E_{amb}$ im dritten Ansteuerintervall 816 nahezu zeitgleich mit dem reflektierten Strahlungspuls aufgenommen werden und anschließend vom Nutzsignal subtrahiert werden, da die Totzeit ($t_4$ - $t_5$) zwischen dem zweiten Ansteuerintervall 814 und dem dritten Ansteuerintervall 816 sehr gering ist, d.h. in der Größenordnung einer Pulsdauer $T_{pulse}$. Auch dies erhöht die Messgeschwindigkeit. Es ist jedoch nicht unbedingt erforderlich die das dritte Transfer-Gate TX3 und die dritte Floating-Diffusion FD3 heranzuziehen, um im dritten Ansteuerintervall 816 das Hintergrundlicht $E_{amb}$ zu detektieren. Gemäß einem anderen Ausführungsbeispiel könnten die an den Sperrschichtkapazitäten der beiden Floating-Diffusions FD1 und FD2 anliegenden Spannung auch unmittelbar nach dem ersten und zweiten Ansteuerintervall 810, 814 ausgelesen werden, so dass nach einer kurzen Reset-Phase in dem dritten Ansteuerintervall 816 entweder das erste oder zweite Transfer-Gate TX1, TX2 angesteuert wird, um durch das Hintergrundlicht $E_{amb}$ generierte Ladungsträger zur entsprechenden Floating-Diffusion FD1 oder FD2 zu transferieren, die dann in einer weiteren Auslesephase ausgewertet wird. Bei diesem Ausführungsbeispiel sind also lediglich drei Transfer-Gates TX1, TX2 und TX4 (zum "Absaugen") erforderlich, was allerdings auf Kosten der erzielbaren Messgeschwindigkeit gegenüber bevorzugten Ausführungsformen mit vier Transfer-Gates geht.

Durch die Trennung von Detektions- und Ausleseknoten ist das Reset-Rauschen bei Ausführungsbeispielen nicht von der photoaktiven Fläche 402 abhängig und kann bei klein gewählten Floating-Diffusions somit deutlich reduziert werden. Dieser Vorteil kommt speziell beim Einsatz von großflächigen Photoaktivgebieten zum Tragen.

Durch das permanente "Absaugen" von während des ersten, zweiten und dritten Ansteuerintervalls liegenden Totzeiten 822, 824, 826 durch Hintergrundbeleuchtung generierten Ladungsträgern wird vermieden, dass sich die auf den Auswertekapazitäten der Floating-Diffusions FDn (n=1,2,3) befindlichen Ladungen bis zum Ausleseintervall 828 durch von der Hintergrundbeleuchtung freigesetzte Ladungsträger verfälschen. Dies erlaubt im Vergleich zum Stand der Technik wesentlich genauere Messergebnisse.

Des Weiteren erlaubt das erfindungsgemäße Konzept die Möglichkeit zur N-fachen Ladungsakkumulation bereits innerhalb der Floating-Diffusions der Pixelstruktur. D.h., der in Fig. 8 dargestellte Ablauf von Strahlungspulsen und Ansteuerintervallen während der ToF-Ladungsintegration 804 kann N-mal wiederholt werden, so dass am Ende des Zeitintervalls 804 auf den Auslesekapazitäten jeweils zumindest näherungsweise die N-fache Ladungsmenge vorhanden ist. Hierdurch kann der Beitrag des Reset-Rauschens minimiert und der Dynamikbereich sowie das Signal-Rausch-Verhältnis erhöht werden.

Obwohl manche Aspekte der vorliegenden Erfindung im Zusammenhang mit einer Vorrichtung beschrieben wurden, versteht es sich, dass diese Aspekte auch eine Beschreibung des entsprechenden Verfahrens darstellen, so dass ein Block oder ein Bauelement einer Vorrichtung auch als ein entsprechender Verfahrensschritt oder als ein Merkmal eines Verfahrensschritts zu verstehen ist. Analog dazu stellen Aspekte, die im Zusammenhang mit einem oder als ein Verfahrensschritt verschieben wurden, auch eine Beschreibung des entsprechenden Blocks oder Details oder Merkmals einer entsprechenden Vorrichtung dar.

Je nach bestimmten Implementierungsanforderungen können Ausführungsbeispiele der Erfindung in Hard- oder in Software implementiert sein. Die Implementierung kann unter Verwendung eines digitalen Speichermediums, beispielsweise einer Floppy-Disk, einer DVD, eine Blu-ray-Disk, einer CD, eines ROM, eines PROM, eines EPROM, eines EEPROM oder eines Flash-Speichers, einer Festplatte oder eines anderen magnetischen oder optischen Speichers durchgeführt werden, auf dem elektronisch lesbare Steuersignale gespeichert sind, die mit einem programmierbaren Computer-System derart zusammenwirken können oder zusammenwirken, dass das jeweilige Verfahren durchgeführt wird. Deshalb kann das digitale Speichermedium computerlesbar sein. Manche Ausführungsbeispiele gemäß der Erfindung umfassen also einen Datenträger, der elektronisch lesbare Steuersignale aufweist, die in der Lage sind, mit einem programmierbaren Computersystem derart zusammen zu wirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahingehend wirksam ist, eines der Verfahren durchzuführen, wenn das Computerprogrammprodukt auf einem Computer oder Mikrocontroller abläuft. Der Programmcode kann beispielsweise auch auf einem maschinenlesbaren Träger gespeichert sein.

**Patentansprüche**

1.  Pixelstruktur (400) zur optischen Abstandsmessung mit folgenden Merkmalen:

    einem Halbleitersubstrat (302);
    einem photoaktiven Bereich (402), der auf dem Substrat (302) integriert ist, zur Erzeugung von Ladungsträgern ansprechend auf auf den photoaktiven Bereich (402) einfallende Strahlung;
    einem Referenzpotentialanschluss (410) für ein Referenzpotential, das als Ladungsträgersenke wirkt;
    einer Mehrzahl von zumindest vier Auswertekapazitäten (408; FDn) in Form von Floatingdiffusion-Bereichen, die lateral beabstandet von einer Kante des photoaktiven Bereichs um den photoaktiven Bereich herum angeordnet sind;

einer Mehrzahl von zumindest vier Transfer-Gates (404; TXn) in Form von MOS-Kondensatoren, die ausgebildet sind, um die erzeugten Ladungsträger aus dem photoaktiven Bereich (402) zu transportieren, wobei die Transfer-Gates ausgebildet sind, um die erzeugten Ladungsträger aus dem photoaktiven Bereich (402) zu einer jeweiligen Auswertekapazität zu transportieren; und wobei die Auswertekapazitäten jeweils über einen Rücksetztransistor (RST FDn) mit dem Referenzpotential koppelbar sind; und

einer Steuerschaltung (406) die ausgebildet ist, um zyklisch, in einem ersten Zyklus,

ein erstes (404-1; TX1) der vier Transfer-Gates während eines mit einem Strahlungspuls (808) einer Strahlungsquelle synchronisierten ersten Ansteuerintervalls (810) anzusteuern, so dass während des ersten Ansteuerintervalls (810) erzeugte erste Ladungsträger von dem photoaktiven Bereich (402) zu einer ersten Auswertekapazität (408-1; FD1) transportiert werden können,

ein zweites (404-2; TX2) der vier Transfer-Gates während eines mit einem Strahlungspuls (808) einer Strahlungsquelle synchronisierten außerhalb des ersten Ansteuerungsintervalls liegenden zweiten Ansteuerintervalls (814) anzusteuern, so dass während des zweiten Ansteuerintervalls (814) erzeugte zweite Ladungsträger von dem photoaktiven Bereich (402) zu einer zweiten Auswertekapazität (408-2; FD2) transportiert werden können,

ein drittes (404-3; TX3) der vier Transfer-Gates während eines außerhalb des ersten und zweiten Ansteuerintervalls liegenden dritten Ansteuerintervalls (816) anzusteuern, so dass während des dritten Ansteuerintervalls (816) erzeugte dritte Ladungsträger von dem photoaktiven Bereich (402) zu einer dritten Auswertekapazität (408-3; FD3) transportiert werden können, und

das weitere (404-4; TX4) der vier Transfer-Gates während einer Zeit (822; 824; 826) außerhalb des ersten, zweiten und dritten Ansteuerintervalls durchgängig anzusteuern, um den photoaktiven Bereich (402) mit dem Referenzpotentialanschluss (410) zu verbinden,

so dass zu jedem Zeitpunkt während des Zyklus zumindest eines der Mehrzahl der Transfer-Gates (404; TXn) angesteuert wird;

wobei die Steuerschaltung (406) ausgebildet ist, um von einem Zyklus zu einem darauffolgenden Zyklus die Ansteuerung der Transfergates zu ändern, so dass eine vierte der vier Auswertekapazitäten, zu dem die erzeugten Ladungsträger aus dem photoaktiven Bereich (402) durch das weitere der vier Transfer-Gates transportierbar sind, zur Ladungsträgerakkumulation während des ersten Ansteuerintervalls verwendet wird.

2. Pixelstruktur gemäß Anspruch 1, bei der die Steuerschaltung so ausgebildet ist, dass sich das zweite Ansteuerintervall (814) unmittelbar an das erste Ansteuerintervall anschließt.

3. Pixelstruktur gemäß Anspruch 2, wobei die Steuerschaltung (406) ausgebildet ist, um die Mehrzahl von Transfer-Gates (404; TXn) derart anzusteuern, so dass das erste, zweite und dritte Ansteuerintervall (810; 814; 816) jeweils einem Vielfachen einer Pulsdauer ($T_{pulse}$) des Strahlungspulses, abhängig von einer zu erwartenden Verzögerungszeit ($T_d$) eines von dem Messobjekt (104) reflektierten Strahlungspulses, entsprechen.

4. Pixelstruktur gemäß Anspruch 2, wobei die Steuerschaltung (406) ausgebildet ist, um die Mehrzahl von Transfer-Gates (404; TXn) derart anzusteuern, so dass das erste Ansteuerintervall (810) zeitlich parallel zu dem Strahlungspuls (808) der Strahlungsquelle verläuft und das erste, zweite und dritte Ansteuerintervall (810; 814; 816) jeweils der Pulsdauer ($T_{pulse}$) des Strahlungspulses entsprechen.

5. Pixelstruktur gemäß einem der Ansprüche 2 bis 4, die ferner eine Auswerteschaltung aufweist, die mit den Auswertekapazitäten (408; FDn) gekoppelt ist und die ausgebildet ist, um eine Distanz (d) zu dem Messobjekt (104) basierend auf

$$d = \frac{c}{2} \frac{Q_{FD,2} - Q_{FD,3}}{Q_{FD,1} + Q_{FD,2} - 2Q_{FD,3}} T_{pulse}$$

zu bestimmen, wobei c die Lichtgeschwindigkeit, $Q_{FD,1}$ während des ersten Ansteuerintervalls (810) auf der ersten Auswertekapazität (408-1; FD1) akkumulierte Ladungen, $Q_{FD,2}$ während des zweiten Ansteuerintervalls (814) auf der zweiten Auswertekapazität (408-2; FD2) akkumulierte Ladungen, $Q_{FD,3}$ während des dritten Ansteuerintervalls (816) auf der dritten Auswertekapazität (408-3; FD3) akkumulierte Ladungen und $T_{pulse}$ die Pulsdauer des Strahlungspulses bedeutet.

6. Pixelstruktur gemäß einem der vorhergehenden Ansprüche, wobei die mit Transfer-Gates (404; TXn) gekoppelten Auswertekapazitäten (408-n) jeweils durch n-dotierte Floating Diffusion Bereiche (FDn) in dem Halbleitersubstrat gebildet sind.

7. Pixelstruktur gemäß einem der vorhergehenden Ansprüche, wobei die mit den Transfer-Gates (404; TXn) gekoppelten Auswertekapazitäten (408-n) jeweils über einen Rücksetztransistor (RST FDn) mit dem Referenzpotential ($\Phi_{REF}$) gekoppelt sind, um die Auswertekapazitäten jeweils während eines Rücksetzintervalls auf das Referenzpotential ($\Phi_{REF}$) aufzuladen.

8. Pixelstruktur gemäß einem der vorhergehenden Ansprüche, wobei der photoaktive Bereich (402) durch ein Photogate (PG), umfassend eine erste Polysiliziumschicht (314) auf einer Siliziumoxidschicht (308) oberhalb eines Halbleitersubstrats (306), gebildet wird.

9. Pixelstruktur gemäß einem der vorhergehenden Ansprüche, wobei die Transfer-Gates (404; TXn) jeweils aus einem Schichtstapel aus einer Polysiliziumschicht (316; 318) oberhalb einer Oxid-Nitrid-Oxid Schicht (502) auf einem Halbleitersubstrat gebildet sind, und wobei die Polysiliziumschicht (316; 318) und die Oxid-Nitrid-Oxid Schicht (502) eine Polysiliziumschicht (314) eines Photogates (PG) des photoaktiven Bereichs teilweise überlappen.

10. Pixelstruktur gemäß einem der vorhergehenden Ansprüche, wobei in dem ersten Zyklus die Ladungsträgersenke (410) durch einen mit dem Referenzpotential ($\Phi_{REF}$) gekoppelten Floating-Diffusion-Bereich (408-4; FD4), der dem weiteren Transfer-Gate (404-4; TX4) zugeordnet ist, gebildet wird, so dass während der ganzen Zeit (822; 824; 826) außerhalb der Ansteuerintervalle (810; 814; 816) der wenigstens drei Transfer-Gates Ladungsträger aus dem photoaktiven Bereich (402) über das weitere Transfer-Gate (404-4; TX4) in Richtung des Referenzpotentials ($\Phi_{REF}$) abfließen können.

11. System zur optischen Abstandsmessung mit folgenden Merkmalen:

   einer Strahlungsquelle (102) zum Aussenden eines Strahlungspulses in Richtung eines Messobjekts (104);
   einer Pixelstruktur (400) gemäß einem der vorhergehenden Ansprüche; und
   eine Synchronisierungseinheit zum Synchronisieren von der Strahlungsquelle (102) und der Steuerschaltung (406) der Pixelstruktur (400), so dass die Steuerschaltung die Transfer-Gates (404; TXn) derart ansteuert, so dass die Ansteuerintervalle (810; 814; 816) der Transfer-Gates von dem Strahlungspuls abhängen.

12. Verfahren zur optischen Abstandsmessung mittels einer Pixelstruktur (400), die ein Halbleitersubstrat (302), einen photoaktiven Bereich (402), der auf dem Substrat (302) integriert ist, zur Erzeugung von Ladungsträgern ansprechend auf auf den photoaktiven Bereich (402) einfallende Strahlung, einen Referenzpotentialanschluss (410) für ein Referenzpotential, das als Ladungsträgersenke wirkt, eine Mehrzahl von zumindest vier Auswertekapazitäten (408; FDn) in Form von Floatingdiffusion-Bereichen, die lateral beabstandet von einer Kante des photoaktiven Bereichs um den photoaktiven Bereich herum angeordnet sind, und einer Mehrzahl von zumindest vier Transfer-Gates (404; TXn) in Form von MOS-Kondensatoren, die ausgebildet sind, um die erzeugten Ladungsträger aus dem photoaktiven Bereich (402) zu einer jeweiligen Auswertekapazität zu transportieren, wobei die Auswertekapazitäten jeweils über einen Rücksetztransistor (RST FDn) mit dem Referenzpotential koppelbar sind; wobei das Verfahren folgende Schritte aufweist, die zyklisch, pro Zyklus, durchgeführt werden:

   Ansteuern eines ersten (404-1; TX1) der vier Transfer-Gates während eines mit einem Strahlungspuls (808) einer Strahlungsquelle synchronisierten ersten Ansteuerintervalls (810), so dass während des ersten Ansteuerintervalls (810) erzeugte erste Ladungsträger von dem photoaktiven Bereich (402) zu einer ersten Auswertekapazität (408-1; FD1) transportiert werden können,
   Ansteuern eines zweiten (404-2; TX2) der vier Transfer-Gates während eines mit einem Strahlungspuls (808) einer Strahlungsquelle synchronisierten außerhalb des ersten Ansteuerungsintervalls liegenden zweiten Ansteuerintervalls (814), so dass während des zweiten Ansteuerintervalls (814) erzeugte zweite Ladungsträger von dem photoaktiven Bereich (402) zu einer zweiten Auswertekapazität (408-2; FD2) transportiert werden können,
   Ansteuern eines dritten (404-3; TX3) der vier Transfer-Gates während eines außerhalb des ersten und zweiten Ansteuerintervalls liegenden dritten Ansteuerintervalls (816), so dass während des dritten Ansteuerintervalls (816) erzeugte dritte Ladungsträger von dem photoaktiven Bereich (402) zu einer dritten Auswertekapazität (408-3; FD3) transportiert werden können, und
   Ansteuern des weiteren (404-4; TX4) der vier Transfer-Gates während einer Zeit (822; 824; 826) außerhalb des ersten, zweiten und dritten Ansteuerintervalls durchgängig anzusteuern, um den photoaktiven Bereich (402) mit dem Referenzpotentialanschluss (410) zu verbinden,

so dass zu jedem Zeitpunkt während des Zyklus zumindest eines der Mehrzahl der Transfer-Gates (404; TXn) angesteuert wird;

Ändern der Ansteuerung der Transfergates von einem Zyklus zu einem darauffolgenden Zyklus, so dass eine vierte der vier Auswertekapazitäten, zu dem die erzeugten Ladungsträger aus dem photoaktiven Bereich (402) durch das weitere der vier Transfer-Gates transportierbar sind, zur Ladungsträgerakkumulation während des ersten Ansteuerintervalls verwendet wird.

13. Verfahren gemäß Anspruch 12, wobei die vier Transfer-Gates (404; TXn) derart angesteuert werden, so dass das erste Ansteuerintervall (810) zeitlich parallel zu dem Strahlungspuls (808) der Strahlungsquelle verläuft und, so dass das erste, zweite und dritte Ansteuerintervall (810; 814; 816) jeweils der Pulsdauer ($T_{pulse}$) des Strahlungspulses entsprechen.

14. Verfahren gemäß einem der Ansprüche 12 bis 13, wobei eine Distanz (d) zu dem Messobjekt basierend auf

$$d = \frac{c}{2} \frac{Q_{FD,2} - Q_{FD,3}}{Q_{FD,1} + Q_{FD,2} - 2Q_{FD,3}} T_{pulse}$$

bestimmt wird, wobei c die Lichtgeschwindigkeit, $Q_{FD,1}$ während des ersten Ansteuerintervalls (810) auf der ersten Auswertekapazität (408-1; FD1) akkumulierte Ladungen, $Q_{FD,2}$ während des zweiten Ansteuerintervalls (814) auf der zweiten Auswertekapazität (408-2; FD2) akkumulierte Ladungen, $Q_{FD,3}$ während des dritten Ansteuerintervalls (816) auf der dritten Auswertekapazität (408-3; FD3) akkumulierte Ladungen und $T_{pulse}$ die Pulsdauer des Strahlungspulses bedeutet.

15. Computerprogramm zur Durchführung der Schritte eines Verfahrens nach einem der Ansprüche 12 bis 14, wenn das Computerprogramm auf einem Computer oder Mikrocontroller abläuft.

**Claims**

1. A pixel structure (400) for optical distance measurement, comprising:

a semiconductor substrate (302);
a photoactive region (402) integrated on the substrate (302) for generating charge carriers responsive to radiation incident on the photoactive region (402);
a reference potential terminal (410) for a reference potential acting as a charge carrier sink;
a plurality of at least four evaluating capacities (408; FDn) in the form of floatingdiffusion regions which are arranged around the photoactive region so as to be laterally spaced apart from an edge of the photoactive region;
a plurality of at least four transfer gates (404; TXn) in the form of MOS capacitors configured to transport the generated charge carriers from the photoactive region (402), wherein the transfer gates are configured to transport the generated charge carriers from the photoactive region (402) to a respective evaluating capacity; and wherein the evaluating capacities each may be coupled to the reference potential via a reset transistor (RST FDn); and
a control circuit (406) configured to cyclically, in a first cycle:

drive a first one (404-1; TX1) of the four transfer gates during a first drive interval (810) synchronized with a radiation pulse (808) of a radiation source so that first charge carriers generated during the first drive interval (810) can be transported from the photoactive region (402) to a first evaluating capacity (408-1; FD1),
drive a second one (404-2; TX2) of the four transfer gates during a second drive interval (814) synchronized with a radiation pulse (808) of a radiation source which is outside the first drive interval so that second charge carriers generated during the second drive interval (814) can be transported from the photoactive region (402) to a second evaluating capacity (408-2; FD2),
drive a third one (404-3 TX3) of the four transfer gates during a third drive interval (816) outside the first and second drive intervals so that third charge carriers generated during the third drive interval (816) can be transported from the photoactive region (402) to a third evaluating capacity (408-3; FD3), and

continuously drive the other one (404-4; TX4) of the four transfer gates during a time (822; 824; 826) outside the first, second and third drive intervals to connect the photoactive region (402) to the reference potential terminal (410),

so that at least one of the plurality of the transfer gates (404; TXn) is driven at every point in time during the cycle; wherein the control circuit (406) is configured to change the driving of the transfer gates from one cycle to a subsequent cycle so that so that a fourth of the four evaluating capacities to which the generated charge carriers from the photoactive region (402) may be transported by the other one of the four transfer gates is used for charge carrier accumulation during the first driving interval.

2.  The pixel structure in accordance with claim 1, wherein the control circuit is configured such that the second drive interval (814) directly follows the first drive interval.

3.  The pixel structure in accordance with claim 2, wherein the control circuit (406) is configured to drive the plurality of transfer gates (404; TXn) such that the first, second and third drive intervals (810; 814; 816) each correspond to a multiple of a pulse duration ($T_{pulse}$) of the radiation pulse, depending on a delay time ($T_d$) to be expected of a radiation pulse reflected from the object of measurement (104).

4.  The pixel structure in accordance with claim 2, wherein the control circuit (406) is configured to drive the plurality of transfer gates (404; TXn) such that the first drive interval (810) is temporally parallel to the radiation pulse (808) of the radiation source, and the first, second and third drive intervals (810; 814; 816) each correspond to the pulse duration ($T_{pulse}$) of the radiation pulse.

5.  The pixel structure in accordance with one of claims 2 to 4, further comprising an evaluating circuit which is coupled to the evaluating capacities (408; FDn) and is configured to determine a distance (d) to the object of measurement (104) based on:

$$ \mathrm{d} = \frac{c}{2} \frac{Q_{FD,2} - Q_{FD,3}}{Q_{FD,1} + Q_{FD,2} - 2Q_{FD,3}} T_{pulse} $$

wherein c represents the speed of light, $Q_{FD,1}$ represents charges accumulated on the first evaluating capacity (408-1; FD1) during the first drive interval (810), $Q_{FD,2}$ represents charges accumulated on the second evaluating capacity (408-2; FD2) during the second drive interval (814), $Q_{FD,3}$ represents charges accumulated on the third evaluating capacity (408-3; FD3) during the third drive interval (816), and $T_{pulse}$ represents the pulse duration of the radiation pulse.

6.  The pixel structure in accordance with one of the preceding claims, wherein the evaluating capacities (408-n) coupled to transfer gates (404; TXn) are each formed by n-doped floating-diffusion regions (FDn) in the semiconductor substrate.

7.  The pixel structure in accordance with one of the preceding claims, wherein the evaluating capacities (408-n) coupled to the transfer gates (404; TXn) are each coupled to the reference potential ($\Phi_{REF}$) via a reset transistor (RST FDn) to charge the evaluating capacities each to the reference potential ($\Phi_{REF}$) during a reset interval.

8.  The pixel structure in accordance with one of the preceding claims, wherein the photoactive region (402) is formed by a photogate (PG) including a first polysilicon layer (314) on a silicon-oxide layer (308) above a semiconductor substrate (306).

9.  The pixel structure in accordance with one of the preceding claims, wherein the transfer gates (404; TXn) are each formed of a layer stack of a polysilicon layer (316; 318) above an oxide-nitride-oxide layer (502) on a semiconductor substrate, and wherein the polysilicon layer (316; 318) and the oxide-nitride-oxide layer (502) partly overlap a polysilicon layer (314) of a photogate (PG) of the photoactive region.

10. The pixel structure in accordance with one of the preceding claims, wherein, in the first cycle, the charge carrier sink (410) is formed by a floating-diffusion region (408-4; FD4) coupled to the reference potential ($\Phi_{REF}$), which is associated to the other transfer gate (404-4; TX4) so that charge carriers may dissipate from the photoactive region (402) via the other transfer gate (404-4; TX4) in the direction of the reference potential ($\Phi_{REF}$) during the entire time (822; 824; 826) outside the drive intervals (810; 814; 816) of the at least three transfer gates.

11. A system for optical distance measurement, comprising:

a radiation source (102) for emitting a radiation pulse in the direction of an object of measurement (104);
a pixel structure (400) in accordance with one of the preceding claims; and
a synchronization unit for synchronizing the radiation source (102) and the control circuit (406) of the pixel structure (400) so that the control circuit drives the transfer gates (404; TXn) such that the drive intervals (810; 814; 816) of the transfer gates are dependent on the radiation pulse.

12. A method for optical distance measurement by means of a pixel structure (400) comprising: a semiconductor substrate (302), a photoactive region (402) integrated on the substrate (302) for generating charge carriers responsive to radiation incident on the photoactive region (402), a reference potential terminal (410) for a reference potential acting as a charge carrier sink, a plurality of at least four evaluating capacities (408; FDn) in the form of floating-diffusion regions which are arranged around the photoactive region so as to be laterally spaced apart from an edge of the photo-active region, and a plurality of at least four transfer gates (404; TXn) in the form of MOS capacitors configured to transport the generated charge carriers from the photoactive region (402) to a respective evaluating capacity, wherein the evaluating capacities each may be coupled to the reference potential via a reset transistor (RST FDn); the method comprising the following steps which are performed cyclically, per cycle:

driving a first one (404-1; TX1) of the four transfer gates during a first drive interval (810) synchronized with a radiation pulse (808) of a radiation source so that first charge carriers generated during the first drive interval (810) can be transported from the photoactive region (402) to a first evaluating capacity (408-1; FD1),
driving a second one (404-2; TX2) of the four transfer gates during a second drive interval (814) synchronized with a radiation pulse (808) of a radiation source which is outside the first drive interval so that second charge carriers generated during the second drive interval (814) can be transported from the photoactive region (402) to a second evaluating capacity (408-2; FD2),
driving a third one (404-3 TX3) of the four transfer gates during a third drive interval (816) outside the first and second drive intervals so that third charge carriers generated during the third drive interval (816) can be transported from the photoactive region (402) to a third evaluating capacity (408-3; FD3), and
continuously driving the other one (404-4; TX4) of the four transfer gates during a time (822; 824; 826) outside the first, second and third drive intervals to connect the photoactive region (402) to the reference potential terminal (410),
so that at least one of the plurality of the transfer gates (404; TXn) is driven at every point in time during the cycle.
changing the driving of the transfer gates from one cycle to a subsequent cycle so that a fourth of the four evaluating capacities to which the generated charge carriers from the photoactive region (402) may be transported by the other one of the four transfer gates is used for charge carrier accumulation during the first driving interval.

13. The method in accordance with claim 12, wherein the four transfer gates (404; TXn) are driven such that the first drive interval (810) is temporally parallel to the radiation pulse (808) of the radiation source and such that the first, second and third drive intervals (810; 814; 816) each correspond to the pulse duration ($T_{pulse}$) of the radiation pulse.

14. The method in accordance with one of claims 12 to 13, wherein a distance (d) to the object of measurement is determined based on:

$$d = \frac{c}{2} \frac{Q_{FD,2} - Q_{FD,3}}{Q_{FD,1} + Q_{FD,2} - 2Q_{FD,3}} T_{pulse}$$

wherein c represents the speed of light, $Q_{FD,1}$ represents charges accumulated on the first evaluating capacity (408-1; FD1) during the first drive interval (810), $Q_{FD,2}$ represents charges accumulated on the second evaluating capacity (408-2; FD2) during the second drive interval (814), $Q_{FD,3}$ represents charges accumulated on the third evaluating capacity (408-3; FD3) during the third drive interval (816), and $T_{pulse}$ represents the pulse duration of the radiation pulse.

15. A computer program for performing the steps of a method in accordance with one of claims 12 to 14 when the computer program runs on a computer or a microcontroller.

**Revendications**

1. Structure de pixels (400) pour la mesure optique de distance, aux caractéristiques suivantes:

   un substrat semi-conducteur (302);
   une zone photo-active (402) qui est intégrée sur le substrat (302), destinée à générer des porteurs de charge en réaction à un rayonnement incident sur la zone photo-active (402);
   une borne de potentiel de référence (410) pour un potentiel de référence qui agit comme puits de porteurs de charge;
   une pluralité d'au moins quatre capacités d'évaluation (408; FDn) sous forme de zones de diffusion flottantes qui sont disposées distantes latéralement d'un bord de la zone photo-active autour de la zone photo-active;
   une pluralité d'au moins quatre portes de transfert (404; TXn) sous forme de condensateurs MOS qui sont conçus pour transporter les porteurs de charge générés hors de la zone photo-active (402), où les portes de transfert sont conçues pour transporter les porteurs de charge générés de la zone photo-active (402) vers une capacité d'évaluation respective; et
   dans laquelle les capacités d'évaluation peuvent être couplées, chacune, par l'intermédiaire d'un transistor de réinitialisation (RST FDn) au potentiel de référence; et
   un circuit de commande (406) qui est conçu pour activer cycliquement, dans un premier cycle, une première (404-1; TX1) des quatre portes de transfert pendant un premier intervalle d'activation (810) synchronisé avec une impulsion de rayonnement (808) d'une source de rayonnement de sorte que les premiers porteurs de charge générés pendant le premier intervalle d'activation (810) puissent être transportés de la zone photo-active (402) vers une première capacité d'évaluation (408-1, FD1),
   pour activer une deuxième (404-2; TX2) des quatre portes de transfert pendant un deuxième intervalle d'activation (814) situé en dehors du premier intervalle d'activation synchronisé avec une impulsion de rayonnement (808) d'une source de rayonnement de sorte que les deuxièmes porteurs de charge générés pendant le deuxième intervalle d'activation (814) puissent être transportés de la zone photo-active (402) vers une deuxième capacité d'évaluation (408-2, FD2),
   pour activer une troisième (404-3, TX3) des quatre portes de transfert pendant un troisième intervalle d'activation (816) situé en dehors du premier et du deuxième intervalle d'activation, de sorte que les troisièmes porteurs de charge générés pendant le troisième intervalle d'activation (816) puissent être transportés de la zone photo-active (402) vers une troisième capacité d'évaluation (408-3, FD3), et
   pour activer en continu l'autre (404-4; TX4) des quatre portes de transfert pendant un temps (822; 824; 826) en dehors du premier, du deuxième et du troisième intervalle d'activation pour connecter la zone photo-active (402) à la borne de potentiel de référence (410),
   de sorte qu'à tout moment pendant le cycle soit activée au moins l'une de la pluralité de portes de transfert (404; TXn);
   dans laquelle le circuit de commande (406) est conçu pour modifier, d'un cycle à un cycle suivant, l'activation des portes de transfert de sorte qu'une quatrième des quatre capacités d'évaluation vers laquelle les porteurs de charge générés peuvent être transportés à partir de la zone photo-active (402) à travers l'autre des quatre portes de transfert soit utilisée pour l'accumulation de porteurs de charge pendant le premier intervalle d'activation.

2. Structure de pixels selon la revendication 1, dans lequel le circuit de commande est conçu de sorte que le deuxième intervalle d'activation (814) se succède immédiatement au premier intervalle d'activation.

3. Structure de pixels selon la revendication 2, dans laquelle le circuit de commande (406) est conçu pour activer la pluralité de portes de transfert (404; TXn) de sorte que le premier, le deuxième et le troisième intervalle d'activation (810; 814; 816) correspondent, chacun, à un multiple d'une durée d'impulsion ($T_{pulse}$) de l'impulsion de rayonnement, en fonction d'une temporisation à attendre ($T_d$) d'une impulsion de rayonnement réfléchie par l'objet de mesure (104).

4. Structure de pixels selon la revendication 2, dans laquelle le circuit de commande (406) est conçu pour activer la pluralité de portes de transfert (404; TXn) de sorte que le premier intervalle d'activation (810) se déroule dans le temps de manière parallèle à l'impulsion de rayonnement (808) de la source de rayonnement et que le premier, le deuxième et le troisième intervalle d'activation (810; 814; 816) correspondent, chacun, à la durée d'impulsion ($T_{pulse}$) de l'impulsion de rayonnement.

**5.** Structure de pixels selon l'une des revendications 2 à 4, présentant par ailleurs un circuit d'évaluation qui est couplé aux capacités d'évaluation (408; FDn) et qui est conçu pour déterminer une distance (d) par rapport à l'objet de mesure (104) sur base de

$$d = \frac{c}{2} \frac{Q_{FD,2} - Q_{FD,3}}{Q_{FD,1} + Q_{FD,2} - 2Q_{FD,3}} T_{pulse}$$

où c signifie la vitesse de la lumière, $Q_{FD,1}$ signifie les charges accumulées pendant le premier intervalle d'activation (810) sur la première capacité d'évaluation (408-1; FD1), $Q_{FD,2}$ signifie les charges accumulées pendant le deuxième intervalle d'activation (814) sur la deuxième capacité d'évaluation (408-2; FD2), $Q_{FD,3}$ signifie les charges accumulées pendant le troisième intervalle d'activation (816) sur la troisième capacité d'évaluation (408-3; FD3), et $T_{pulse}$ signifie la durée d'impulsion de l'impulsion de rayonnement.

**6.** Structure de pixels selon l'une des revendications précédentes, dans laquelle les capacités d'évaluation (408-n) couplées aux portes de transfert (404; TXn) sont formées, chacune, par des zones de diffusion flottantes (FDn) à dopage n dans le substrat semi-conducteur.

**7.** Structure de pixels selon l'une des revendications précédentes, dans laquelle les capacités d'évaluation (408-n) couplées aux portes de transfert (404; TXn) sont couplées, chacune, par l'intermédiaire d'un transistor de réinitialisation (RST FDn) au potentiel de référence ($\Phi_{REF}$), pour charger chacun des condensateurs d'évaluation pendant un intervalle de réinitialisation au potentiel de référence ($\Phi_{REF}$).

**8.** Structure de pixels selon l'une des revendications précédentes, dans laquelle la zone photo-active (402) est formée par une grille photonique (PG) comportant une première couche de polysilicium (314) sur une couche d'oxyde de silicium (308) au-dessus d'un substrat semi-conducteur (306).

**9.** Structure de pixels selon l'une des revendications précédentes, dans laquelle les portes de transfert (404; TXn) sont formées, chacune, d'un empilement de couches composé d'une couche de polysilicium (316; 318) au-dessus d'une couche d'oxyde-nitrure-oxyde (502) sur un substrat semi-conducteur, et dans laquelle la couche de polysilicium (316; 318) et la couche d'oxyde-nitrure-oxyde (502) viennent partiellement en recouvrement avec une couche de polysilicium (314) d'une grille photonique (PG) de la zone photo-active.

**10.** Structure de pixels selon l'une des revendications précédentes, dans laquelle, dans le premier cycle, le puits de porteurs de charge (410) est formé par une zone de diffusion flottante (408-4; FD4) couplée au potentiel de référence ($\Phi_{REF}$) qui est associée à l'autre porte de transfert (404-4; TX4), de sorte que, pendant tout le temps (822; 824; 826) en dehors des intervalles d'activation (810; 814; 816) des au moins trois portes de transfert, les porteurs de charge puissent s'écouler hors de la zone photo-active (402) à travers l'autre porte de transfert (404-4; TX4) en direction du potentiel de référence ($\Phi_{REF}$).

**11.** Système de mesure de distance optique, aux caractéristiques suivantes:

une source de rayonnement (102) destinée à émettre une impulsion de rayonnement en direction d'un objet de mesure (104);
une structure de pixels (400) selon l'une des revendications précédentes; et
une unité de synchronisation destinée à synchroniser la source de rayonnement (102) et le circuit de commande (406) de la structure de pixels (400), de sorte que le circuit de commande active les portes de transfert (404; TXn) de sorte que les intervalles d'activation (810; 814; 816) des portes de transfert dépendent de l'impulsion de rayonnement.

**12.** Procédé de mesure de distance optique au moyen d'une structure de pixels (400) qui comporte un substrat semi-conducteur (302), une zone photo-active (402) qui est intégrée sur le substrat (302), pour générer des porteurs de charge en réaction à un rayonnement incident sur la zone photo-active (402), une borne de potentiel de référence (410) pour un potentiel de référence qui sert de puits de charge, une pluralité d'au moins quatre capacités d'évaluation (408; FDn) sous forme de zones de diffusion flottantes qui sont disposées distantes latéralement d'un bord de la zone photo-active autour de la zone photo-active, et une pluralité d'au moins quatre portes de transfert (404; TXn) sous forme de condensateurs MOS qui sont conçus pour transporter les porteurs de charge générés de la zone photo-active (402) vers une capacité d'évaluation respective,

dans lequel les capacités d'évaluation peuvent être couplées, chacune, par l'intermédiaire d'un transistor de réinitialisation (RST FDn) au potentiel de référence;

dans lequel le procédé présente les étapes suivantes qui sont réalisées cycliquement, par cycle, par le fait de:

activer une première (404-1, TX1) des quatre portes de transfert pendant un premier intervalle d'activation (810) synchronisé avec une impulsion de rayonnement (808) d'une source de rayonnement, de sorte que les premiers porteurs de charge générés pendant le premier intervalle d'activation (810) puissent être transportés de la zone photo-active (402) vers une première capacité d'évaluation (408-1, FD1),

activer une deuxième (404-2; TX2) des quatre portes de transfert pendant un deuxième intervalle d'activation (814) situé en dehors du premier intervalle d'activation et synchronisé avec une impulsion de rayonnement (808) d'une source de rayonnement, de sorte que les deuxièmes porteurs de charge générés pendant le deuxième intervalle d'activation (814) puissent être transportés de la zone photo-active (402) vers une deuxième capacité d'évaluation (408-2, FD2),

activer une troisième (404-3; TX3) des quatre portes de transfert pendant un troisième intervalle d'activation (816) situé en dehors du premier et du deuxième intervalle d'activation, de sorte que les troisièmes porteurs de charge générés pendant le troisième intervalle d'activation (816) puissent être transportés de la zone photo-active (402) vers une troisième capacité d'évaluation (408-3, FD3), et

activer en continu l'autre (404-4; TX4) des quatre portes de transfert pendant un laps de temps (822; 824; 826) en dehors du premier, du deuxième et du troisième intervalle d'activation, pour connecter la zone photo-active (402) à la borne de potentiel de référence (410),

de sorte qu'à tout moment pendant le cycle soit activée au moins l'une de la pluralité de portes de transfert (404; TXn);

modifier l'activation des portes de transfert d'un cycle à un cycle suivant, de sorte qu'une quatrième des quatre capacités d'évaluation vers laquelle les porteurs de charge générés peuvent être transportés à partir de la zone photo-active (402) à travers l'autre des quatre portes de transfert soit utilisée pour l'accumulation de porteurs de charge pendant le premier intervalle d'activation.

13. Procédé selon la revendication 12, dans lequel les quatre portes de transfert (404; TXn) sont activées de sorte que le premier intervalle d'activation (810) se déroule dans le temps de manière parallèle à l'impulsion de rayonnement (808) de la source de rayonnement et, de sorte que le premier, le deuxième et le troisième intervalle d'activation (810; 814; 816) correspondent, chacun, à la durée d'impulsion ($T_{pulse}$) de l'impulsion de rayonnement.

14. Procédé selon l'une des revendications 12 à 13, dans lequel une distance (d) par rapport à l'objet de mesure est déterminée sur base de

$$d = \frac{c}{2} \frac{Q_{FD,2} - Q_{FD,3}}{Q_{FD,1} + Q_{FD,2} - 2Q_{FD,3}} T_{pulse},$$

où c signifie la vitesse de la lumière, $Q_{FD,1}$ signifie les charges accumulées pendant le premier intervalle d'activation (810) sur la première capacité d'évaluation (408-1; FD1), $Q_{FD,2}$ signifie les charges accumulées pendant le deuxième intervalle d'activation (814) sur la deuxième capacité d'évaluation (408-2; FD2), $Q_{FD,3}$ signifie les charges accumulées pendant le troisième intervalle d'activation (816) sur la troisième capacité d'évaluation (408-3; FD3), et $T_{pulse}$ signifie la durée d'impulsion de l'impulsion de rayonnement.

15. Programme d'ordinateur pour réaliser les étapes d'un procédé selon l'une des revendications 12 à 14 lorsque le programme d'ordinateur est exécuté sur un ordinateur ou un microcontrôleur.

FIG 1

**FIG 2**

EP 2 290 393 B1

FIG 3

EP 2 290 393 B1

400

408

FD3

TX3 — 404

404

402

FD1 | TX1

A ----- photoaktiver Bereich ----- A'

TX2 | FD2

408

408 | 404

TX4

FD4

406

410

408

FIG 4

**FIG 5**

FIG 6

Metallschild    Strahlung (hf)    Metallschild

FD1 to SF    RST    TX1    PG    TX2    RST    FD2 to SF

$V_{REF}$    FD1    TX1    PG    TX2    FD2    $V_{REF}$

Poly 1    Poly 2    Poly 1    Poly 2    Poly 1

$n^+$    $n^-$    $\phi_{TX-}$    $\phi_{PG-}$    $\phi_{TX-}$    $n^-$    $n^+$

$\phi_{TX+}$    $\phi_{PG+}$

402

elektrostatisches Potential $\phi$,V

$\phi_{REF}$    $p^-$ - epitaktische Schicht    $\phi_{REF}$

$p^+$-Substrat

FIG 7

EP 2 290 393 B1

FIG 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19833207
- US 7186965 B
- EP 2009002570 W
- US 20070158770 A1
- US 7436496 B2
- US 6825455 B
- US 7060957 B
- US 20090134396 A1